# EUROPEAN PATENT SPECIFICATION

(11) **EP 1 089 305 B1**
(45) Date of publication and mention of the grant of the patent: **06.02.2008**
(21) Application number: 00121440.2
(22) Date of filing: 29.09.2000
(51) Int. Cl.: H01G 9/20, H01M 10/40, C07D 213/28, C07D 213/30, C07D 233/54, H01B 1/12

(54) **Electrolyte composition, photoelectric conversion device and photo-electrochemical cell**
Elektrolyt-Zusammensetzung, photoelektrische Umwandlungsvorrichtung und photoelektrochemische Zelle
Composition d'électrolyte, dispositif de conversion photoélectrique et cellule photoélectrochimique

(30) Priority: 29.09.1999 JP 27732299
(43) Date of publication of application: 04.04.2001
(73) Proprietor: FUJIFILM Corporation, Minato-ku Tokyo (JP)
(72) Inventor: Wariishi, Koji, Minami-Ashigara-shi, Kanagawa-ken 258 (JP)
(74) Representative: Solf, Alexander

(56) References cited:
- WO-A-95/18456
- DD-A- 25 752
- DE-A- 2 408 813
- DE-A- 2 720 416
- DE-A- 3 922 852
- GB-A- 1 302 000
- PATENT ABSTRACTS OF JAPAN vol. 001, no. 027 (C-008), 28 March 1977 (1977-03-28) -& JP 51 140892 A (TOKYO DENKI DAIGAKU), 4 December 1976 (1976-12-04)
- PATENT ABSTRACTS OF JAPAN vol. 1999, no. 13, 30 November 1999 (1999-11-30) -& JP 11 224831 A (SHOWA DENKO KK), 17 August 1999 (1999-08-17)
- PAPAGEORGIOU N ET AL: "The Performance and Stability of Ambient Temperature Molten Salts for Solar Cell Applications" JOURNAL OF THE ELECTROCHEMICAL SOCIETY, ELECTROCHEMICAL SOCIETY. MANCHESTER, NEW HAMPSHIRE, US, vol. 143, no. 10, October 1996 (1996-10), pages 3099-3108, XP002118482 ISSN: 0013-4651
- PYATI R ET AL: "VOLTAMMETRY AND CONDUCTIVITY OF A POLYETHER-PYRIDINIUM ROOM TEMPERATURE MOLTEN SALT ELECTROLYTE AND OF ITS POLYMER ELECTROLYTE SOLUTIONS IN POLYDIMETHYLSILOXANE" JOURNAL OF THE ELECTROCHEMICAL SOCIETY, ELECTROCHEMICAL SOCIETY. MANCHESTER, NEW HAMPSHIRE, US, vol. 143, no. 2, 1 February 1996 (1996-02-01), pages 401-405, XP002051053 ISSN: 0013-4651
- PATENT ABSTRACTS OF JAPAN vol. 014, no. 150 (P-1025), 22 March 1990 (1990-03-22) -& JP 02 012133 A (AGENCY OF IND SCIENCE & TECHNOL), 17 January 1990 (1990-01-17)
- PATENT ABSTRACTS OF JAPAN vol. 004, no. 007 (C-070), 19 January 1980 (1980-01-19) -& JP 54 144377 A (FUJISAWA PHARMACEUT CO LTD), 10 November 1979 (1979-11-10)
- DATABASE BEILSTEIN BEILSTEIN INSTITUTE FOR ORGANIC CHEMISTRY, FRANKFURT-MAIN, DE; Citation No 5900094 XP002287660 & PERNAK J ET AL: "1-Alkoxymethyl- and 1-Alkylthiomethyl-4-dimethylaminopyridiniu m chlorides" HETEROCYCLES, vol. 37, no. 1, 1994, pages 311-322,
- DATABASE BEILSTEIN BEILSTEIN INSTITUTE FOR ORGANIC CHEMISTRY, FRANKFURT-MAIN, DE; Citation No 5904553 XP002287661 & PERNAK J ET AL: "Synthese und antimikrobielle Wirkung von 1-Alkoxymethyl- und 1-Alkylthiomethyl-4-dimethylaminopyridiniu m chlriden" PHARMAZIE, vol. 49, no. 7, 1994, pages 532-534, & DATABASE BEILSTEIN BEILSTEIN INSTITUTE FOR ORGANIC CHEMISTRY, FRANKFURT-MAIN, DE; Citation No 5974595
- KOMURA T ET AL: "Electrostatic incorporation of anthraquinonesulfonate ions into a polypyrrole film containing pyridinium groups" ELECTROCHIMICA ACTA, ELSEVIER SCIENCE PUBLISHERS, BARKING, GB, vol. 42, no. 6, 1997, pages 985-991, XP004016981 ISSN: 0013-4686
- COSNIER S ET AL: "ALKYLAMMONIUM AND PYRIDINIUM GROUP-CONTAINING POLYPYRROLES, A NEW CLASS OF ELECTRONICALLY CONDUCTING ANION-EXCHANGE POLYMERS" JOURNAL OF ELECTROANALYTICAL CHEMISTRY AND INTERFACIAL ELECTROCHEMISTRY, ELSEVIER, AMSTERDAM, NL, vol. 271, no. 1/2, 1989, pages 69-81, XP000995070 ISSN: 0022-0728
- DATABASE BEILSTEIN BEILSTEIN INSTITUTE FOR ORGANIC CHEMISTRY, FRANKFURT-MAIN, DE; BRN 1394392 XP002287662 & KUGITA ET AL: CHEM. PHARM. BULL., vol. 11, 1963, pages 986-988,
- DATABASE BEILSTEIN BEILSTEIN INSTITUTE FOR ORGANIC CHEMISTRY, FRANKFURT-MAIN, DE; BRN 1646595 XP002287663 & MASUI ET AL: J. CHEM. SOC. PERKIN TRANS. 2, 1976,
- DATABASE BEILSTEIN BEILSTEIN INSTITUTE FOR ORGANIC CHEMISTRY, FRANKFURT-MAIN, DE; BRN 3839436 XP002287664 & SUGASAWA ET AL: CHEM. PHARM. BULL., vol. 6, 1958, page 111,
- DATABASE BEILSTEIN BEILSTEIN INSTITUTE FOR ORGANIC CHEMISTRY, FRANKFURT-MAIN, DE; BRN 3886252 XP002287665 & KOENIG: J. PRAKT. CHEM., vol. 70, no. 2, 1904, page 45,
- DATABASE BEILSTEIN BEILSTEIN INSTITUTE FOR ORGANIC CHEMISTRY, FRANKFURT-MAIN, DE; BRN 4084607 XP002287666 & SHEINKMAN ET AL: SOV. PROG. CHEM. ENGL. TRANSL., vol. 38, no. 6, 1972,
- KNIER B L ET AL: "Mechanism of Reactions of N-(Methoxymethyl)-N,N-dimethylanilinium Ions with Nucleophilic reagents" JOURNAL OF THE AMERICAN CHEMICAL SOCIETY, AMERICAN CHEMICAL SOCIETY, WASHINGTON, DC, US, vol. 102, no. 22, 1980, pages 6789-6798, XP002287656 ISSN: 0002-7863
- TONG L K J ET AL: "The Mechanism of Dye Formation in Color Photography. VII. Intermediate Bases in the Deamination of Quinonediimines" JOURNAL OF THE AMERICAN CHEMICAL SOCIETY, AMERICAN CHEMICAL SOCIETY, WASHINGTON, DC, US, vol. 82, 1960, pages 1988-1996, XP002287657 ISSN: 0002-7863
- CULLUM N R ET AL: "Effective Charge on the Nucleophile and Leaving Group during the Stepwise Transfer of the Triazinyl Group between Pyridines in Aqueous Solution" JOURNAL OF THE AMERICAN CHEMICAL SOCIETY, AMERICAN CHEMICAL SOCIETY, WASHINGTON, DC, US, vol. 117, 1995, pages 9200-9205, XP002287658 ISSN: 0002-7863
- HUTCHINGS M G ET AL: "The Effect on the Colour of the Diarylazo chromogen, and Electronic Substituent Constants, of the N-pyridinium Group" DYES AND PIGMENTS, vol. 9, 1988, pages 385-392, XP002287659

## Description

### BACKGROUND OF THE INVENTION

The present invention relates to an electrolyte composition excellent in durability and charge-transporting capability, a photoelectric conversion device comprising the electrolyte composition, and a photo-electrochemical cell composed thereof. The present invention also relates to novel imidazolium compound, which can be used for the electrolyte composition.

Conventionally, an electrolysis solution prepared by dissolving an electrolyte salt in a solvent has been used as an electrolyte for electrochemical devices such as a cell, a capacitor, a sensor, a display device, a recording device, etc. However, the electrochemical device comprising such an electrolysis solution is unreliable because it often causes leakage of the solution during long-term operation or storage.

Nature, vol. 353, pp. 737 to 740 (1991), United States Patent No. 4,927,721, etc. disclosed a photoelectric conversion device comprising dye-sensitized semiconductor particles, and a photo-electrochemical cell composed thereof. However, since the device also comprises the electrolysis solution in a charge transfer layer, there is still a fear that its photoelectric conversion efficiency is extremely lowered, or its function is lost by leakage or depletion of the electrolysis solution during the long-term operation or storage.

Under these circumstances, International Patent No. 93/20565 disclosed a photoelectric conversion device comprising a solid electrolyte. Further, Nippon Kagaku Kaishi, 7, 484 (1997), Japanese Patent Laid-Open No. 7-2881142, Solid State Ionics, 89, 263 (1986) and Japanese Patent Laid-Open No. 9-27352 proposed a photoelectric conversion device using a solid electrolyte comprising a cross-linked, poly(ethylene oxide)-based polymer. However, the devices using the solid electrolyte are insufficient in photoelectric conversion characteristics, especially short-circuit current density. Additionally, durability of the device is also insufficient.

Further, disclosed in WO 95/18456, Japanese Patent Laid-Open No. 8-259543, Denki Kagaku, 65, 11, 923 (1997), etc. are methods for preventing the leakage and depletion of the electrolytic solution, in which a pyridinium salt, an imidazolium salt or a triazolium salt is used as the electrolyte for the photoelectric conversion device. The salts are liquid at room temperature, called as "room temperature-molten salt". In the methods, the durability of the device is improved because a solvent for dissolving the electrolyte such as water and organic solvents is not necessary or needed only a little amount. However, the device using the room temperature-molten salt generally has such a defect as a low open circuit voltage and insufficient photoelectric conversion efficiency.

### OBJECT AND SUMMARY OF THE INVENTION

Accordingly, an object of the present invention is to provide an electrolyte composition excellent in durability and charge-transporting capability, a photoelectric conversion device comprising the electrolyte composition that exhibits high durability and excellent photoelectric conversion properties, and a photo-electrochemical cell composed thereof.

Another object of the present invention is to provide novel imidazolium compound, which can be used for the electrolyte composition.

As a result of intense research in view of the above object, the inventor has found that an electrolyte composition comprising a compound represented by the following general formula (1) is excellent in the durability and charge-transporting capability. The present invention has been accomplished by the finding. 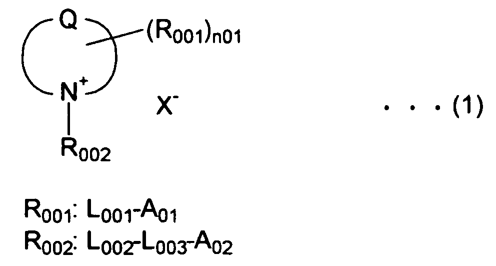 wherein Q represents an atomic group forming an aromatic cation having a 5-membered ring structure with a nitrogen atom; R₀₀₁ represents L₀₀₁-A₀₁ (in which L₀₀₁ is a single bond or a divalent linking group, A₀₁ is a substituent when L₀₀₁ is a single bond, and A₀₁ is a hydrogen atom or a substituent when L₀₀₁ is a divalent linking group); n01 represents 0 or an integer of 1 to the maximum number of R₀₀₁ attachable to Q, and R₀₀₁'s may be the same or different groups when n01 is 2; R₀₀₂ represents L₀₀₂-L₀₀₃-A₀₂ (in which L₀₀₂ is an unsubstituted alkylene group, L₀₀₃ is a single bond or a divalent linking group, and A₀₂ is a hydrogen atom or a substituent);
X⁻ represents an anion; and at least one of A₀₁ and A₀₂ is a substituent, a conjugate acid of a compound obtained by adding a hydrogen atom thereto exhibiting a pKa value of 3 to 15, wherein the aromatic cation formed by said Q is an imidazolium cation.

A photoelectric conversion device of the present invention has an electrically conductive layer, a photosensitive layer, a charge transfer layer and a counter electrode, and the charge transfer layer comprises the electrolyte composition of the present invention. The photoelectric conversion device exhibits high durability and excellent photoelectric conversion properties.

A photo-electrochemical cell of the present invention is composed of the photoelectric conversion device.

With respect to the electrolyte composition, the photoelectric conversion device and the photo-electrochemical cell of the present invention, the durability, the charge-transporting capability and the photoelectric conversion properties are further improved by satisfying any of the following conditions (1) to (8).
(1) Q is preferably composed of atoms selected from the group consisting of carbon, hydrogen, nitrogen and oxygen atoms.
(2) The aromatic cation formed by Q is particularly preferably an imidazolium cation.
(3) It is preferable that the compound represented by the general formula (1) is further represented by the following general formula (2): 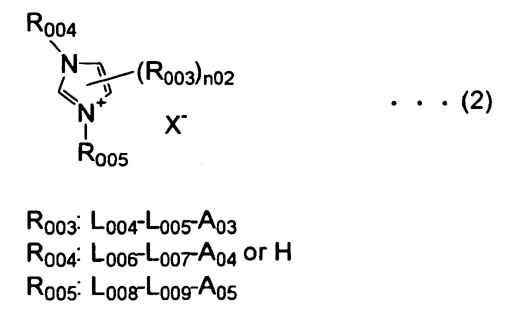
   In the general formula (2), R₀₀₃ represents L₀₀₄-L₀₀₅-A₀₃ (in which L₀₀₄ is an substituted alkylene group, L₀₀₅ is a single bond or a divalent linking group, and A₀₃ is a hydrogen atom or a substituent; n02 represents an integer of 0 to 1; R₀₀₄ represents a hydrogen atom or L₀₀₆-L₀₀₇-A₀₄ (in which L₀₀₆ is an unsubstituted alkylene group, L₀₀₇ is a single bond or a divalent linking group, and A₀₄ is a hydrogen atom or a substituent); R₀₀₅ represents L₀₀₈-L₀₀₉-A₀₅ (in which L₀₀₈ is an unsubstituted alkylene group, L₀₀₉ is a single bond or a divalent linking group, and A₀₅ is a hydrogen atom or a substituent); X⁻ represents an anion; and at least one of A₀₃ to A₀₅ is a substituent, a conjugate acid of a compound obtained by adding a hydrogen atom thereto exhibiting a pKa value of 3 to 8.
(4) The substituent, a conjugate acid of a compound obtained by adding a hydrogen atom thereto exhibiting a pKa value of 3 to 8, is particularly preferably an imidazolyl group.
(5) A solvent-content of the electrolyte composition is preferably 10 weight % or less based on the total thereof.
(6) X⁻ is more preferably I⁻, NCS⁻, BF₄⁻, N⁻(CF₃SO₂)₂, or an anion represented by the following general formula (AN-1) or (AN-2):

   R₀₁₃-COO⁻ (AN-1)

   R₀₁₄-SO₃⁻ (AN-2)

   wherein R₀₁₃ is an unsubstituted alkyl group or a perfluoroalkyl group; and R₀₁₄ is an unsubstituted alkyl group or a perfluoroalkyl group.
(7) It is preferable that the electrolyte composition comprises an iodine salt and/or iodine in addition to the compound represented by the general formula (1).
(8) The photosensitive layer of the photoelectric conversion device preferably comprises semiconductor fine particles sensitized by a dye. The semiconductor fine particles are preferably metal chalcogenide fine particles, and the metal chalcogenide fine particles preferably contain titanium oxide fine particles. The dye is preferably a metal complex dye and/or a polymethine dye.

A novel imidazolium compound represented by the following general formula (3) can be preferably used for the electrolyte composition according to the present invention.

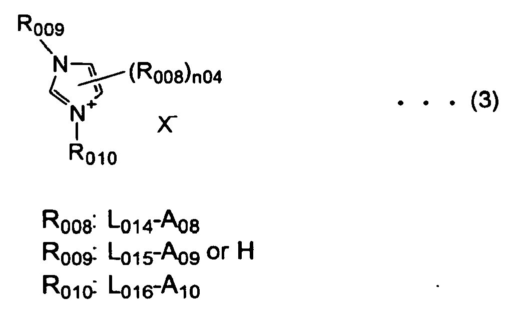

In the general formula (3), R₀₀₈ represents L₀₁₄-A₀₈ (in which L₀₁₄ is a divalent linking group selected from the group consisting of an alkylene group, -O- and a combination thereof, and A₀₈ is a hydrogen atom or a substituent);

R₀₀₉ represents L₀₁₅-A₀₉ (in which L₀₁₅ is a divalent linking group selected from the group consisting of an alkylene group, -O- and a combination thereof, and A₀₉ is a hydrogen atom or a substituent); R₀₁₀ represents L₀₁₆-A₁₀ (in which L₀₁₆ is a divalent linking group selected from the group consisting of an alkylene group, -O- and a combination thereof, and A₁₀ is a hydrogen atom or a substituent); X⁻ represents an anion; at least one of A₀₈ to A₁₀ is a substituent, a conjugate acid of a compound obtained by adding a hydrogen atom thereto exhibiting a pKa value of 3 to 8.

### BRIEF DESCRIPTION OF THE DRAWINGS

Fig. 1 is a partial cross sectional view showing a preferable structure of a photoelectric conversion device of the present invention,
Fig. 2 is a partial cross sectional view showing a preferable structure of a photoelectric conversion device of the present invention,
Fig. 3 is a partial cross sectional view showing a preferable structure of a photoelectric conversion device of the present invention,
Fig. 4 is a partial cross sectional view showing a preferable structure of a photoelectric conversion device of the present invention,
Fig. 5 is a partial cross sectional view showing a preferable structure of a photoelectric conversion device of the present invention,
Fig. 6 is a partial cross sectional view showing a preferable structure of a photoelectric conversion device of the present invention,
Fig. 7 is a partial cross sectional view showing a preferable structure of a photoelectric conversion device of the present invention,
Fig. 8 is a partial cross sectional view showing a preferable structure of a photoelectric conversion device of the present invention, and
Fig. 9 is a partial cross sectional view showing an example of a structure of a substrate-integrated type solar cell module comprising a photoelectric conversion device of the present invention.

### DETAILED DESCRIPTION OF THE PREFERRED EMBODIMENTS

### [1] Electrolyte Composition

An electrolyte composition according to the present invention can be used as a solvent for a chemical reaction, a metal plating, etc., or used for a CCD (charge coupling device) camera, various kinds of photoelectric conversion devices or cells, etc. The composition is preferably used for a lithium ion secondary batteries or a photo-electrochemical cell. The constitutive elements of the electrolyte composition will be described in detail below.

### (A) Compound Represented by the General Formula (1)

The electrolyte composition of the present invention comprises a compound represented by the following general formula (1): 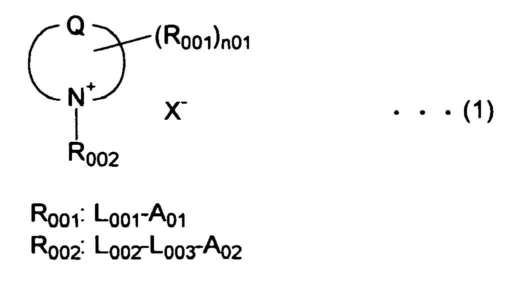 The compound represented by the general formula (1) is preferably a salt with a low melting point, a so-called "molten salt", more preferably such that is liquid at room temperature (around 25 °C), a so-called "room temperature-molten salt". The melting point is preferably 100 °C or less, more preferably 80 °C or less, particularly preferably 60 °C or less.

In the case where the compound represented by the general formula (1) is the room temperature-molten salt, the compound can be generally used as the electrolyte with little solvent, and most thereof can be singly used as the electrolyte. Even if the compound is solid at room temperature, it can be used as the electrolyte by adding a little amount of solvent or additive thereto to liquefy. Alternatively, the compound can be incorporated in the photoelectric conversion device without any additives by: a method where the compound penetrates into an electrode of the device by heat-dissolution; a method comprising the steps of dissolving the compound in a solvent with a low boiling temperature such as methanol, acetonitrile and methylene chloride, making the resultant solution penetrate into an electrode, and evaporating the solvent by heating; etc.

In the general formula (1), Q represents an atomic group forming an aromatic cation having a 5-membered ring structure with a nitrogen atom. Q is preferably composed of atoms selected from the group consisting of carbon, hydrogen, nitrogen and oxygen atoms. As for the 5-membered ring formed by Q, preferred is such a ring as an imidazole ring.

In the general formula (1), R₀₀₁ represents L₀₀₁-A₀₁ (in which L₀₀₁ is a single bond or a divalent linking group, A₀₁ is a substituent when L₀₀₁ is a single bond, and A₀₁ is a hydrogen atom or a substituent when L₀₀₁ is a divalent linking group). n01 indicating the number of R₀₀₁ represents 0 or an integer of 1 to the maximum number of R₀₀₁ attachable to Q. R₀₀₁'s may be the same or different groups when n01 is 2.

When L₀₀₁ is a divalent linking group, examples thereof include an alkylene group, -O-, a combination thereof, etc.

When A₀₁ is a substituent, examples thereof include an alkyl group, an aryl group, a heterocyclic group, etc. A₀₁ may further have a substituent, which is preferably an alkyl group such as a methyl group, an ethyl group.

In the general formula (1), R₀₀₂ represents L₀₀₂-L₀₀₃-A₀₂ (in which L₀₀₂ is an unsubstituted alkylene group, L₀₀₃ is a single bond or a divalent linking group, and A₀₂ is a hydrogen atom or a substituent).

Examples of L₀₀₂ include a methylene group, an ethylene group, etc. L₀₀₂ is preferably a methylene group or an ethylene group.

When L₀₀₃ is a divalent linking group, examples thereof include an alkylene group, -O-, a combination thereof, etc. L₀₀₃ is preferably -(OCH₂CH₂)ₙ-,-(OCH₂CH₂)ₙ-CH₂-,-(OCH₂CH₂)ₙ-O-, -(OCH₂CH₂CH₂)ₙ-, -O-, particularly preferably -(OCH₂CH₂)ₙ-, or -O-. Incidentally, n is each an integer of 1 to 3.

When A₀₂ is a substituent, examples thereof include an alkyl group, an aryl group, a heterocyclic group, etc. Among them, A₀₂ is preferably an alkyl group, an aryl group, a heterocyclic group, more preferably a nitrogen-containing heterocyclic group. A₀₂ may further have a substituent, whose preferred examples are the same as those of the substituent on A₀₁ mentioned above.

The compound represented by the general formula (1) may form an oligomer through R₀₀₂. The oligomer is preferably a dimmer.

At least one of A₀₁ and A₀₂ is a substituent, a conjugate acid of a compound obtained by adding a hydrogen atom thereto exhibiting a pKa value of 3 or more. The pKa value is preferably 3 to 8. Such a substituent is preferably an amino group such as a dimethylamino group, a nitrogen-containing heterocyclic group such an imidazolyl group, a pyridyl group, a 2-methyl pyridyl group. The imidazolyl group may have a substituent, which is preferably an alkyl group such as a methyl group.

In the general formula (1), X⁻ represents an anion. Preferred examples of X⁻ include halide ions such as I⁻, NCS⁻, BF₄⁻, N(CF₃SO₂)₂, and an anion represented by the following general formula (AN-1) or (AN-2):

R₀₁₃-COO⁻ (AN-1)

R₀₁₄-SO₃⁻ (AN-2)

X⁻ is more preferably I⁻, NCS⁻, BF₄⁻, N⁻(CF₃SO₂)₂, or an anion represented by the general formula (AN-1) or (AN-2).

In the general formula (AN-1), R₀₁₃ is: an unsubstituted alkyl group preferably having 1 atom, which may be straight, such as a methyl group; a perfluoroalkyl group preferably having 1 atom such as a trifluoromethyl group. R₀₁₃ is more preferably an alkyl group or a perfluoroalkyl group having 1 atom, particularly preferably a perfluoroalkyl group having 1 carbon atom.

In the general formula (AN-2), R₀₁₄ is: an unsubstituted alkyl group preferably having 1 carbon atom, such as a methyl group; a perfluoroalkyl group preferably having 1 carbon atom such as a trifluoromethyl group.

It is preferable that the compound represented by the general formula (1) is further represented by the following general formula (2):

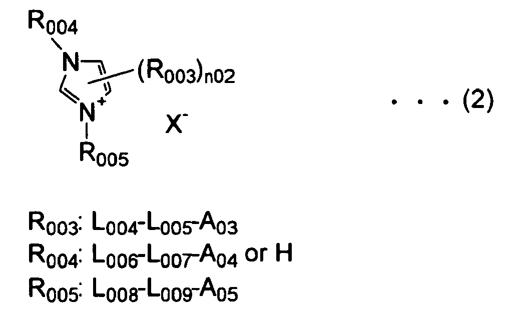

In the general formula (2), R₀₀₃ represents L₀₀₄-L₀₀₅-A₀₃, n02 indicating the number of R₀₀₃ represents an integer of 0 to 1, R₀₀₄ represents L₀₀₆-L₀₀₇-A₀₄, and R₀₀₅ represents L₀₀₈-L₀₀₉-A₀₅.

L₀₀₄, L₀₀₆ and L₀₀₈ are independently an unsubstituted alkylene group, with examples being the same as those of L₀₀₂ mentioned above. L₀₀₅, L₀₀₇ and L₀₀₉ are independently a single bond or a divalent linking group. Preferred examples of the divalent linking group are the same as those in the case of L₀₀₃.

A₀₃ to A₀₅ are independently a hydrogen atom or a substituent. Preferred examples of the substituent are the same as those in the case of A₀₂. A₀₃ to A₀₅ may further have a substituent with preferred examples being the same as those of a substituent on A₀₁ mentioned above.

The compound represented by the general formula (2) may form an oligomer through any of R₀₀₃ to R₀₀₅. The oligomer is preferably a dimmer.

At least one of A₀₃ to A₀₅ in the general formula (2) is a substituent, a conjugate acid of a compound obtained by adding a hydrogen atom thereto exhibiting a pKa value of 3 or more, respectively. The pKa value is preferably 3 to 8. Preferable embodiments of such a substituent are the same as those in the case of A₀₁ and A₀₂ mentioned above.

In the general formula (2), X⁻ represents an anion with preferable examples which is the same as those of X⁻ in the general formula (1).

A novel imidazolium compound represented by the following general formula (3) can be preferably used for the electrolyte composition according to the present invention.

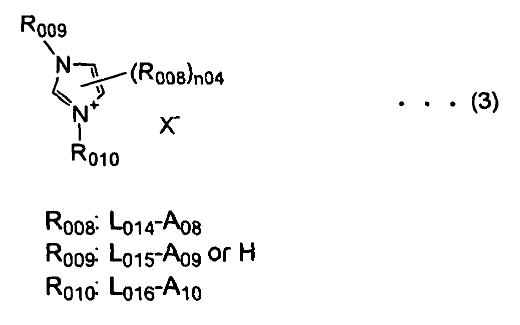

In the general formula (3), R₀₀₈ represents L₀₁₄-A₀₈, n04 indicating the number of R₀₀₈ represents an integer of 0 to 1, R₀₀₉ represents L₀₁₅-A₀₉, and R₀₁₀ represents L₀₁₆-A₁₀.

L₀₁₄ to L₀₁₆ are independently a divalent linking group selected from the group consisting of an alkylene group, -O- and a combination thereof. Preferable examples of L₀₁₄ to L₀₁₆ include -(CH₂)ₘ-, -(OCH₂CH₂)ₙ-,-(OCH₂CH₂)ₙ-CH₂-, -(OCH₂CH₂CH₂)ₙ-, -(CH₂)ₘ-(OCH₂CH₂)ₙ-, -(CH₂)ₘ-(OCH₂CH₂)ₙ-CH₂, -(CH₂)ₘ-(OCH₂CH₂CH₂)ₙ-, etc. Incidentally, *m* and *n* are each an integer of 1 to 3.

A₀₈ to A₁₀ are independently a hydrogen atom or a substituent. Preferred examples of the substituent are the same as those in the case of A₀₂-A₀₅ and A₀₈ to A₁₀ may further have a substituent with preferred examples being the same as those of a substituent on A₀₁ mentioned above.

At least one of A₀₈ to A₁₀ in the general formula (3) is a substituent, a conjugate acid of a compound obtained by adding a hydrogen atom thereto exhibiting a pKa value of 3 or more, respectively. The pKa value is preferably 3 to 8. Preferable embodiments of such a substituent are the same as those in the case of A₀₁ and A₀₂ mentioned above.

In the general formula (3), X⁻ represents an anion with preferable examples which is the same as those of X⁻ in the general formula (1).

Specific examples of the compound represented by the general formula (1) used for the electrolyte composition of the present invention will be illustrated below without intention of restricting the scope of the present invention defined by the claims attached hereto.

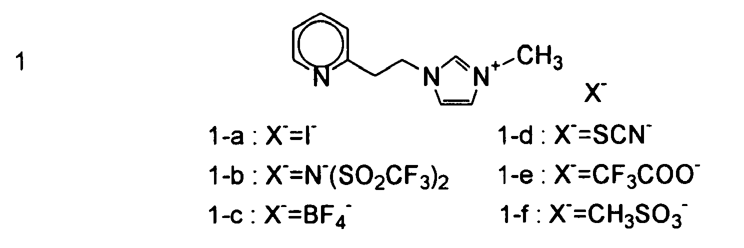

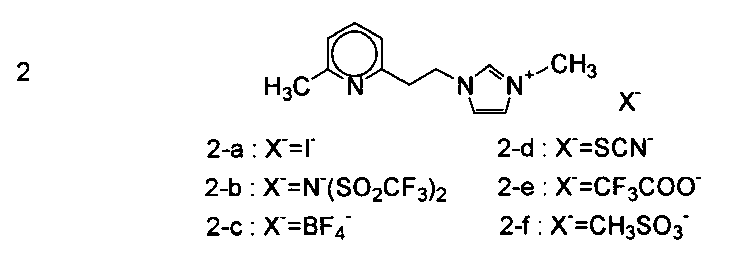

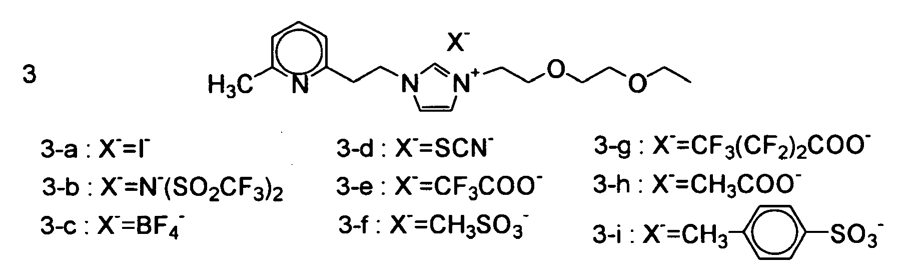

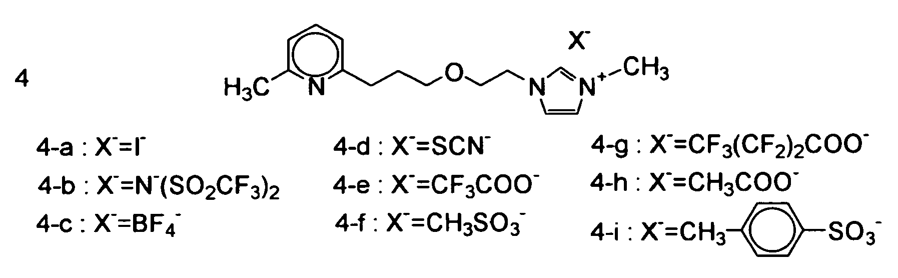

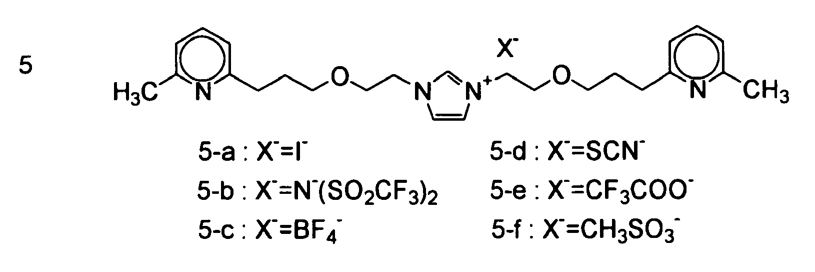

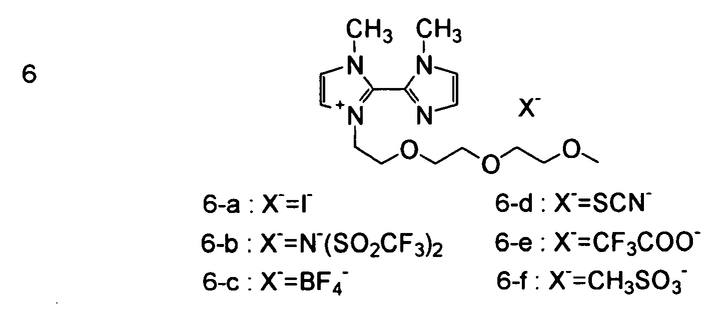

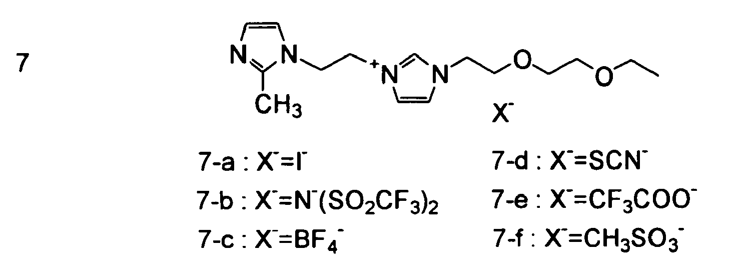

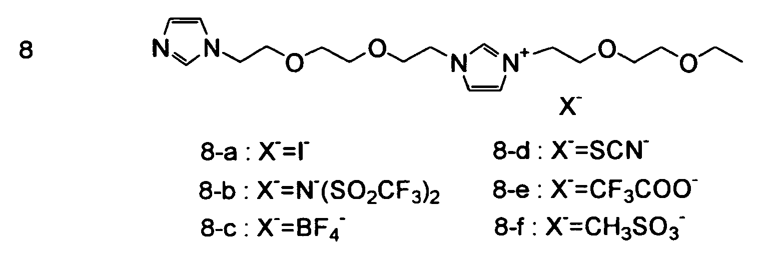

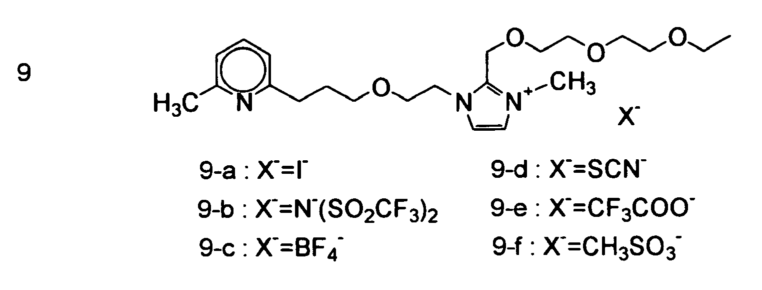

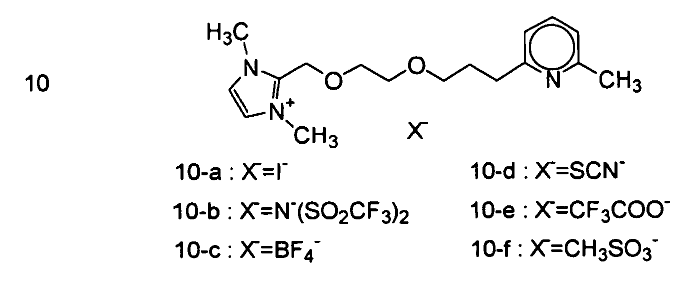

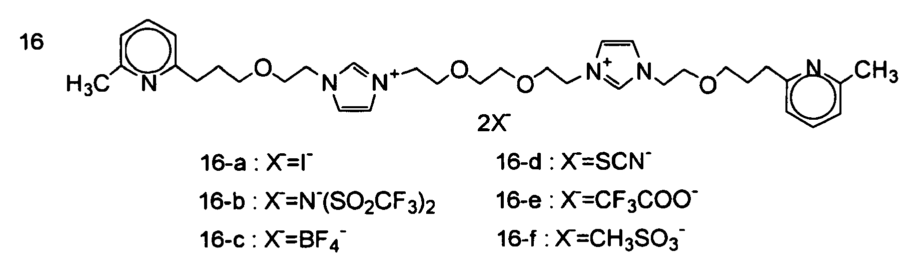

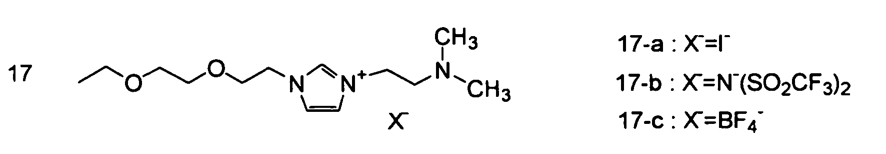

### (B) Iodine salt and/or Iodine

The electrolyte composition of the present invention preferably comprises an iodine salt and/or iodine. Particularly, when the compound represented by the general formula (1) is not an iodine salt, it is preferable that the known iodine salt such as a pyridinium salt, an imidazolium salt and a triazolium salt disclosed in WO 95/18456, Japanese Patent Laid-Open No. 8-259543, Denki Kagaku, 65, 11, 923 (1997), etc. is added to the electrolyte composition. In the case where the compound represented by the general formula (1) is an iodine salt, the electrolyte composition may further comprise another salt with no iodide ion.

A content of the compound represented by the general formula (1) is preferably 10 weight % or more, more preferably 20 to 95 weight % based on the entire electrolyte composition, when it is used together with the other electrolyte salt. A content of the iodine salt is preferably 10 weight % or more, more preferably 50 to 95 weight % based on the entire electrolyte composition.

In the case where the electrolyte composition comprises iodine, an iodine-content is preferably 0.1 to 20 weight %, more preferably 0.5 to 5 weight % based on the entire electrolyte composition.

The preferred iodine salt used together with the compound represented by the general formula (1) is such that represented by any of the following general formula[e] (Y-a):

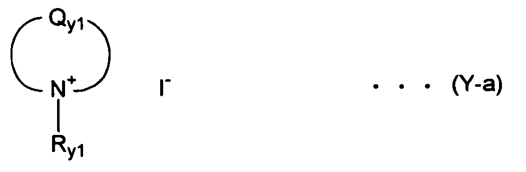

In the general formula (Y-a), Q_{y1} represents an atomic group forming an aromatic cation having a 5-membered ring structure with a nitrogen atom. Q_{y1} is preferably composed of atoms selected from the group consisting of carbon, hydrogen, nitrogen and oxygen and atoms.

As for the 5-membered ring formed by Q_{y1}, preferred is such a ring as an imidazole ring.

R_{y1} in the general formula[e] (Y-a) represents: a substituted or unsubstituted alkyl group preferably having 1 to 4 carbon atom, which may be straight, such as a methyl group, an ethyl group, a propyl group, an isopropyl group, a pentyl group, etc. R_{y1} is more preferably an alkyl group having 2 to 4 carbon atoms.

Q_{y1} and R_{y1} in the general formula (Y-a) may have a substituent. Preferable examples thereof include: an alkoxy group such as a methoxy group, an ethoxy group and 2-ethoxyethoxy group; etc.

### (C) Solvent

The electrolyte composition of the present invention may comprise a solvent. A solvent-content of the electrolyte composition is preferably 50 weight % or less, more preferably 30 weight % or less, particularly preferably 10 weight % or less based on the total thereof.

The solvent is preferably has an excellent ionic conductibility. Such a solvent exhibits a low viscosity and a high ionic mobility, and/or high permittivity and actual carrier concentration. Examples of the solvent include: carbonates such as ethylene carbonate and propylene carbonate; heterocyclic compounds such as 3-methyl-2-oxazolidinone; ethers such as dioxan and diethyl ether; chain ethers such as ethyleneglycol dialkylethers, propyleneglycol dialkylethers, polyethyleneglycol dialkylethers and polypropyleneglycol dialkylethers; alcohols such as methanol, ethanol, ethyleneglycol monoalkylethers, propyleneglycol monoalkylethers, polyethyleneglycol monoalkylethers and polypropyleneglycol monoalkylethers; glycols such as ethylene glycol, propylene glycol, polyethylene glycol, polypropylene glycol and glycerin; nitriles such as acetonitrile, glutarodinitrile, methoxyacetonitrile, propionitrile, benzonitrile and biscyanoethyl ether; esters such as carboxylates, phosphates and phosphonates; aprotic polar solvents such as dimethylsulfoxide (DMSO) and sulfolane; water; etc. These solvents may be mixed to use.

### (D) Others

The electrolyte composition of the present invention may be gelled (solidified) at practical use. The gelation may be achieved by: adding a polymer; adding an oil-gelling agent; polymerization of multifunctional monomers; a cross-linking reaction of a polymer; etc.

In the case where the electrolyte composition is gelled by adding a polymer, compounds described in "Polymer Electrolyte Reviews-1 and 2", edited by J. R. MacCaLLum and C. A. Vincent, ELSEIVER APPLIED SCIENCE may be used as the polymer. Polyacrylonitrile or poly(vinylidene fluoride) is preferably used.

In the case where the electrolyte composition is gelled by adding an oil-gelling agent, compounds described in J. Chem. Soc. Japan, Ind. Chem. Soc., 46, 779 (1943), J. Am. Chem. Soc., 111, 5542 (1989), J. Chem. Soc., Chem. Commun., 390 (1993), Angew. Chem. Int. Ed. Engl., 35, 1949 (1996), Chem. Lett., 885 (1996), and J. Chem. Soc., Chem. Commun., 545 (1997) may be used as the oil-gelling agent. Of these compounds, preferred are those having an amide structure.

In the case where a gel electrolyte composition is formed by polymerization of multifunctional monomers, the gelation is preferably achieved by the method comprising the steps of: preparing a solution composed of the multifunctional monomers, a polymerization initiator, the electrolyte and a solvent; forming a sol electrolyte layer on an electrode having a dye by a casting method, a coating method, a soaking method, an impregnation method, etc.; and radical polymerizing the multifunctional monomers. It is preferable that the multifunctional monomer has two or more ethylenycally unsaturated groups. Preferable examples thereof include divinyl benzene, ethyleneglycol diacrylate, ethyleneglycol dimethacrylate, diethyleneglycol diacrylate, diethyleneglycol dimethacrylate, triethyleneglycol diacrylate, triethyleneglycol dimethacrylate, pentaerythritol triacrylate and trimethylolpropane triacrylate.

The solution composed of the multifunctional monomers, etc. may further contain unifunctional monomers. Preferable examples of the unifunctional monomers include: acrylic acid and α-alkylacrylic acids (e.g. acrylic acid, methacrylic acid, itaconic acid, etc.), and esters or amides derived therefrom (e.g. methyl acrylate, ethyl acrylate, *n*-propyl acrylate, *i*-propyl acrylate, *n*-butyl acrylate, *i*-butyl acrylate, *t*-butyl acrylate, *n*-pentyl acrylate, 3-pentyl acrylate, *t*-pentyl acrylate, *n*-hexyl acrylate, 2,2-dimethylbutyl acrylate, *n-*octyl acrylate, 2-ethylhexyl acrylate, 4-methyl-2-propylpentyl acrylate, cetyl acrylate, *n*-octadecyl acrylate, cyclohexyl acrylate, cyclopentyl acrylate, benzyl acrylate, hydroxyethyl acrylate, 2-hydroxypropyl acrylate, 2-methoxyethyl acrylate, 2-ethoxyethyl acrylate, 2-methoxyethoxyethyl acrylate, phenoxyethyl acrylate, 3-methoxybutyl acrylate, ethylcarbitol acrylate, 2-methyl-2-nitropropyl acrylate, 2,2,2-trifluoroethyl acrylate, octafluoropentyl acrylate, heptadecafluorodecyl acrylate, methyl methacrylate, *n*-butyl methacrylate, *i-*butyl methacrylate, *t*-butyl methacrylate, *t*-pentyl methacrylate, *n*-octadecyl methacrylate, benzyl methacrylate, hydroxyethyl methacrylate, 2-hydroxypropyl methacrylate, 2-methoxyethyl methacrylate, 2-ethoxyethyl methacrylate, 2-methoxyethoxyethyl methacrylate, dimethylaminoethyl methacrylate, 2,2,2-trifluoroethyl methacrylate, tetrafluoropropyl methacrylate, hexafluoropropyl methacrylate, heptadecafluorodecyl methacrylate, ethyleneglycol ethyl carbonate methacrylate, 2-isobornyl methacrylate, 2-norbornylmethyl methacrylate, 5-norbornen-2-ylmethyl methacrylate, 3-methyl-2-norbornylmethyl methacrylate, acrylamide, *N*-*i*-propyl acrylamide, *N*-*n*-butyl acrylamide, *N-t*-butyl acrylamide, *N,N*-dimethyl acrylamide, *N*-methylol acrylamide, diacetone acrylamide, 2-acrylamido-2-methylpropane sulfonic acid, acrylamidopropyltrimethyl ammonium chloride, methacrylamide, *N*-methylmethacrylamide, *N-*methylolmethacrylamide, etc.); vinyl esters (e.g. vinyl acetate, etc.); maleic acid and fumaric acid, and esters derived therefrom (e.g. dimethyl maleate, dibutyl maleate, diethyl fumarate, etc.); acrylonitrile and methacrylonitrile; dienes (e.g. butadiene, cyclopentadiene, isoprene, etc.); aromatic vinyl compounds (e.g. styrene, *p*-chlorostyrene, *t*-butylstyrene, α-methylstyrene, sodium *p-*styrenesulfonate, etc.); *N*-vinylformamide, *N*-vinyl-*N-*methylformamide, *N-*vinylacetamide, and *N*-vinyl-*N*-methylacetamide; vinyl sulfonic acid; sodium vinylsulfonate, sodium allylsulfonate and sodium methacrylsulfonate; vinylidene fluoride and vinylidene chloride; vinyl alkyl ethers (e.g. methyl vinyl ether, etc.); ethylene, propylene, 1-butene and isobutene; and *N*-phenyl maleimide.

The weight ratio of the multifunctional monomers to all the monomers in the solution is preferably 0.5 to 70 weight %, more preferably 1.0 to 50 weight %.

The above-described monomers can be polymerized by general radical polymerization method described in Takayuki Otsu and Masaetsu Kinoshita, "Kobunshi Gosei no Jikkenho" (Kagaku Dojin), Takayuki Otsu, Koza Jugo "Hannoron 1 Rajikaru Jugo (I)" (Kagaku Dojin), etc. The radical polymerization of the monomers may be achieved by heating, light or electron ray, or electro-chemical method. Among them, heat-polymerization is particularly preferable.

Preferable examples of the polymerization initiator used in the present invention include: azo initiators such as 2,2'-azobis(isobutyronitrile), 2,2'-azobis(2,4-dimethylvaleronitrile), dimethyl 2,2'-azobis(2-methylpropionate) and dimethyl 2,2'-azobis(isobutyate); peroxide initiators such as lauryl peroxide, benzoyl peroxide and *t*-butyl peroctoate; etc. The weight ratio of the initiator to all the monomers is preferably 0.01 to 20 weight %, more preferably 0.1 to 10 weight %.

The weight ratio of the monomers accounting for the gel electrolyte is preferably in the range of 0.5 to 70 weight %, more preferably 1.0 to 50 weight %.

In the case where the gelation of the electrolyte composition is accomplished by the cross-linking reaction of polymer, a polymer having a group with a cross-linking reactivity is preferably added to the composition in combination with a cross-linking agent. The group with a cross-linking reactivity is preferably a nitrogen-containing heterocyclic group such as a pyridine group, an imidazole group, a thiazole group, an oxazole group, a triazole group, a morpholine group, a piperidine group, a piperazine group, etc. Preferable cross-linking agent is a multi-functional electrophilic agent, which can be attacked by the nitrogen atom, such as multi-functional alkyl halides, aralkyl halides, sulfonates, acid anhydrides, acyl chlorides and isocyanates.

To the electrolyte composition of the present invention may be added: a metal iodide such as LiI, NaI, CsI and CaI₂; a metal bromide such as LiBr, NaBr, KBr, CsBr and CaBr₂; a quaternary ammonium bromide such as a tetralkyl ammonium bromide and pyridinium bromide; a metal complex such as a ferrocyanide-ferricyanide and a ferrocene-ferricinium ion; a sulfur compound such as sodium polysulfide and alkylthiol-alkyldisulfide; a viologen dye; hydroquinone-quinone; etc. These compounds may be used as a mixture.

Further, to the electrolyte composition of the present invention may be added a basic compound such as *t*-butylpyridine, 2-picoline, 2,6-lutidine, etc. described in J. Am. Ceram. Soc., 80 (12), 3157 to 3171 (1997). The concentration of the basic compound is preferably 0.05 to 2 M based on the electrolyte composition.

When the electrolyte composition is used for the charge transfer layer of the photoelectric conversion device, the water-content of the charge transfer layer is preferably 10,000 ppm or less, more preferably 2,000 ppm or less, and particularly preferably 100 ppm or less.

### [2] Photoelectric Conversion Device

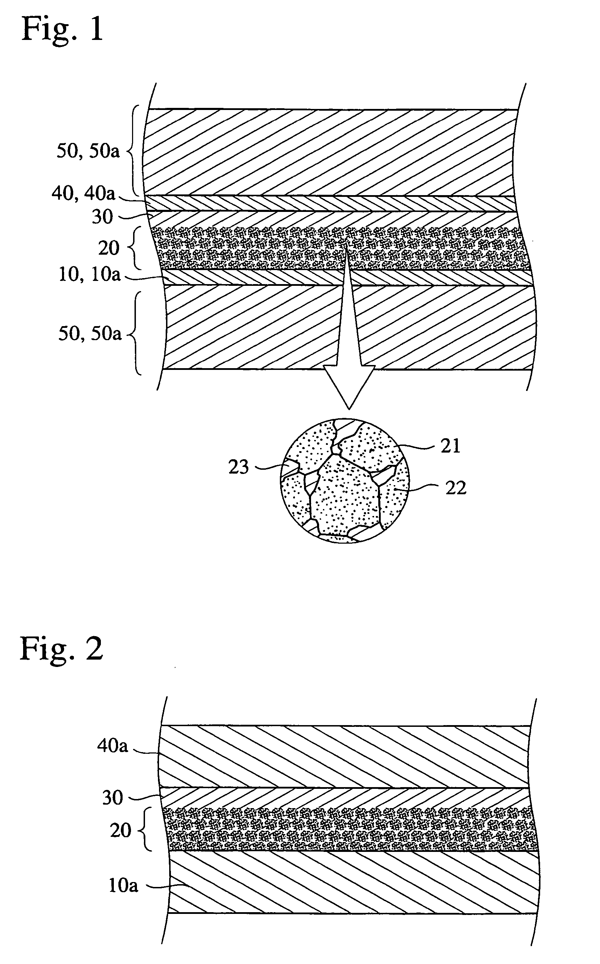

The photoelectric conversion device according to the present invention has an electrically conductive layer, a photosensitive layer, a charge transfer layer and a counter electrode. The charge transfer layer comprises the electrolyte composition of the present invention mentioned above. It is preferable that the photoelectric conversion device comprises an electrically conductive layer 10, a photosensitive layer 20 composed of semiconductor fine particles 21 sensitized by a dye 22 and an electrolyte 23 penetrated into voids among the particles, a charge transfer layer 30, and a counter electrically conductive layer 40 laminated in this order, as shown in Fig. 1.
The electrolyte 23 is preferably composed of the same materials as the components used in the charge transfer layer 30. On the electrically conductive layer 10 and/or the counter electrically conductive layer 40 may be disposed a substrate 50 to improve the strength of the photoelectric conversion device. Hereinafter in the present invention, a layer composed of the electrically conductive layer 10 and the substrate 50 disposed thereon if necessary is referred to as "a conductive support", and a layer composed of the counter electrically conductive layer 40 and the substrate 50 disposed thereon if necessary is referred to as a "counter electrode". A photo-electrochemical cell of the present invention is constituted by connecting the device to an outer circuit. Incidentally, the electrically conductive layer 10, the counter electrically conductive layer 40 and the substrate 50 shown in Fig. 1 may be a transparent electrically conductive layer 10a, a transparent counter electrically conductive layer 40a and a transparent substrate 50a, respectively.

In the photoelectric conversion device of the present invention shown in Fig. 1, a light injected to the photosensitive layer 20 excites the dye 22, etc., excited high energy electrons therein are transported to a conduction band of the semiconductor fine particles 21, and they are diffused to reach to the electrically conductive layer 10. At this time, the dye 22 is in oxidized form.
According to the photo-electrochemical cell, electrons in the electrically conductive layer 10 are returned to the oxidized dye through the counter electrically conductive layer 40 and the charge transfer layer 30 while working in the outer circuit, so that the dye 22 is regenerated. The photosensitive layer 20 acts as a negative electrode. In a boundary of each layer such as a boundary between the electrically conductive layer 10 and the photosensitive layer 20, a boundary between the photosensitive layer 20 and the charge transfer layer 30, a boundary between the charge transfer layer 30 and the counter electrically conductive layer 40, etc., components of each layer may be diffused and mixed. Each of the layers will be explained in detail below.

### (A) Conductive Support

The conductive support is composed of: (1) a single layer of the electrically conductive layer; or (2) two layers of the electrically conductive layer and the substrate. The substrate is not necessary in the case where the electrically conductive layer has a high strength and can sufficiently seal the photoelectric conversion device.

In the case (1), the electrically conductive layer is preferably made of a material having a sufficient strength and an electrical conductivity such as a metal, etc.

In the case (2), as the conductive support may be used the substrate having the electrically conductive layer comprising an electrically conductive agent at the photosensitive layer side. Preferable examples of the electrically conductive agent include: metals such as platinum, gold, silver, copper, aluminum, rhodium and indium; carbon; and electrically conductive metal oxides such as indium-tin composite oxides and tin oxides doped with fluorine; etc. The thickness of the electrically conductive layer is preferably 0.02 to 10 µm.

The surface resistance of the conductive support is preferably as low as possible. The surface resistance is preferably 100 Ω/square or less, more preferably 40 Ω/square or less. The lowest limit thereof is generally approximately 0.1 Ω/square, not limited in particular.

When a light is irradiated from the conductive support side, it is preferred that the conductive support is substantially transparent. Herein, the term "substantially transparent" means the support has a light-transmittance of 10 % or more. The light-transmittance is preferably 50 % or more, particularly preferably 70 % or more.

The transparent conductive support is preferably constituted by forming the transparent electrically conductive layer of an electrically conductive metal oxide on the transparent substrate of such material as a glass and a plastic by coating or vapor deposition. Of such supports, particularly preferred is a transparent electrically conductive substrate made of a low-cost soda-lime float glass, on which the electrically conductive layer composed of a tin oxide doped with fluorine is deposited. As for a low-cost and flexible photoelectrical conductive device or solar cell, a transparent polymer film disposed the electrically conductive layer thereon is preferably used as the transparent conductive support. Examples of materials for the transparent polymer film include tetracetylcellulose (TAC), polyethylene terephthalate (PET), polyethylene naphthalate (PEN), syndiotactic polystyrene (SPS), polyphenylenesulfide (PPS), polycarbonate (PC), polyarylate (PAr), polysulfone (PSF), polyestersulfone (PES), polyetherimide (PEI), cyclic polyolefin, brominated phenoxy, etc. To secure a sufficient transparency, the coating amount of the electrically conductive metal oxide is preferably 0.01 to 100 g per 1 m² of the glass or plastic substrate.

It is preferable that a metal lead is used to reduce a resistance of the transparent conductive support. Material for the metal lead is preferably aluminum, copper, silver, gold, platinum, nickel, etc., particularly preferably aluminum or silver. The metal lead disposed the transparent electrically conductive layer of a tin oxide doped with fluorine, an ITO film, etc. thereon is preferably applied on the transparent substrate by a vapor deposition method, a sputtering method, or the like. It is also preferable that after forming the transparent electrically conductive layer on the transparent substrate, the metal lead is applied thereon. The reduction in quantity of incident light owing to the metal lead is suppressed to preferably 10 % or less, more preferably 1 to 5 %.

### (B) Photosensitive Layer

The photosensitive layer preferably comprises semiconductor fine particles sensitized by a dye. The semiconductor fine particles act as a so-called "photosensitive substance" to absorb a light, thereby conducting a charge separation and generating electrons and positive holes. With respect to the dye-sensitized semiconductor fine particles, the light-absorption and the generation of electrons and positive holes are primarily caused in the dye, the semiconductor fine particles receive and then convey the electrons.

### (1) Semiconductor Fine Particles

Used as the semiconductor fine particles may be: simple semiconductors such as silicone and germanium; III-V series compound semiconductors; metal chalcogenides such as oxides, sulfides and selenides; compounds with a perovskite structure such as strontium titanate, calcium titanate, sodium titanate, barium titanate and potassium niobate; etc. The semiconductor fine particles are preferably metal chalcogenide fine particles.

Preferable examples of the metal chalcogenide include: oxides of titanium, tin, zinc, iron, tungsten, zirconium, hafnium, strontium, indium, cerium, yttrium, lanthanum, vanadium, niobium or tantalum; sulfides of cadmium, zinc, lead, silver, antimony or bismuth; selenides of cadmium or lead; and cadmium telluride; etc. Examples of other compound semiconductors include: phosphides of zinc, gallium, indium and cadmium; selenides of gallium-arsenic or copper-indium; and copper-indium sulfide; etc.

Preferable specific examples of the semiconductor used in the present invention include Si, TiO₂, SnO₂, Fe₂O₃, WO₃, ZnO, Nb₂O₅, CdS, ZnS, PbS, Bi₂S₃, CdSe, CdTe, GaP, InP, GaAs, CuInS₂ and CuInSe₂. Of these semiconductors, more preferred are TiO₂, ZnO, SnO₂, Fe₂O₃, WO₃, Nb₂O₅, CdS, PdS, CdSe, InP, GaAs, CuInS₂ and CuInSe₂, particularly preferred are TiO₂ and Nb₂O₅, and the most preferred is TiO₂.

The semiconductor may have a single crystal or poly crystal structure. The single crystal semiconductor is preferred from a viewpoint of a conversion efficiency, while the poly crystal semiconductor is preferred from viewpoints of a production cost, security of raw materials, an energy-payback time, etc.

The particle size of the semiconductor fine particles is generally in the nm to µm level. The mean size of primary particles, which is obtained from a diameter of a circle equivalent to a projected area, is preferably 5 to 200 nm, more preferably 8 to 100 nm. Further, the mean size of the secondary semiconductor fine particles in dispersion is preferably 0.01 to 100 µm.

Two or more kinds of particles having a different particle size distribution may be mixed to use in the photosensitive layer. In this case, the average particle size of the smaller particles is preferably 5 nm or less. To improve a light-capturing rate of the photoelectric conversion device by scattering a ray of light, the semiconductor fine particles having a large particle size, e.g. approximately 300 nm, may be added to the mixture composing the semiconductor layer.

Preferred as a method for producing the semiconductor fine particles are: sol-gel methods described in Sumio Sakka, "Science of a sol-gel method", Agune Shofusha (1998), Technical information Association, "Thin film-coating technology by a sol-gel method" (1995), etc.; and gel-sol methods described in Tadao Sugimoto, "Synthesis of mono-dispersion particles and control of their size and form by a novel gel-sol method", and MATERIA, Vol. 35, No. 9, pp. 1012 to 1018 (1996). The method developed by Degussa Company, which comprises preparing oxides by subjecting chlorides to a high temperature hydrolysis in an oxyhydrogen salt is also preferred.

In the case where titanium oxide is used as the semiconductor fine particles, any of the above-described sol-gel methods, gel-sol methods and high temperature hydrolysis method is preferably used, and further a sulfuric acid method and a chlorine method described in Manabu Seino, "Titanium oxide - properties and applied technique", Gihodo Shuppan, (1997) may be used. Also preferred are sol-gel methods described in Christophe J. Barb'e, et al, Journal of American Ceramic Society, Vol. 80, No. 12, pp. 3157 to 3171 (1997) and Burnside, et al, Chemistry of Materials, Vol. 10, No. 9, pp. 2419 to 2425.

### (2) Semiconductor Fine Particle Layer

The semiconductor fine particles may be coated on the conductive support by a method where a dispersion solution or a colloid solution containing the particles is applied on the electrically conductive layer, the above-mentioned sol-gel method, etc. A wet-type film production method is relatively advantageous for the mass production of the photoelectric conversion device, improvement of properties of semiconductor fine particle solution and adaptability of the conductive support, etc. As such a wet-type film production method, a coating method and a printing method are typical examples.

As a method for preparing the dispersion solution containing the semiconductor fine particles, the sol-gel method mentioned above may be used. Further, the dispersion solution may be prepared by crushing the semiconductor in a mortar, dispersing the semiconductor while grinding in a mill, or precipitating the semiconductor fine particles in a solvent when the semiconductor is synthesized.

As a dispersion solvent, water or organic solvents such as methanol, ethanol, isopropyl alcohol, dichloromethane, acetone, acetonitrile, ethyl acetate, etc. may be used. At dispersing, a polymer, a surfactant, an acid, a chelating agent, etc. may be used as a dispersing agent, if necessary.

Preferred coating methods are: a roller method and a dip method as an application series; an air-knife method and a blade method as a metering series; etc. Further, preferable as a method where an application and metering can be performed at the same time are a wire-bar method disclosed in JP-B-58-4589, a slide-hopper method described in United States Patent Nos. 2,681,294, 2,761,419, 2,761,791, etc., an extrusion method, a curtain method, etc. Furthermore, as for a wide use, a spin method and a spray method are preferred. As a wet-type printing method, three major printing methods comprising a relief printing, an offset printing and a gravure printing, and an intaglio printing, a gum-printing, a screen printing, etc. are preferred. A preferable film-production method may be selected from these methods in accordance with viscosity of the solution and a wet thickness.

The viscosity of the dispersion solution materially depends on the kind and dispersion property of the semiconductor fine particles, the kind of a solvent and additives such as a surfactant and a binder. For a high viscosity solution (e.g. 0.01 to 500 Poise), an extrusion method, a cast method, a screen-printing method, etc. are preferably used. On the other hand, for a low viscosity solution (e.g. 0.1 Poise or less), a slide-hopper method, a wire-bar method and a spin method are preferably used to form a uniform film. An extrusion method may be used for the low viscosity solution if it is coated to some extent. A wet-type film-production method may be properly selected in accordance with the viscosity of the coating solution, the coating amount, the support, a coating speed and so on.

The layer of the semiconductor fine particles is not limited to a single layer. The dispersion solutions each comprising the semiconductor fine particles having a different particle size may be subjected to a multi-layer coating. Further, coating solutions each containing different kinds of semiconductor fine particles, binder, or additives may be subjected to a multi-layer coating. A multi-layer coating is also effective when a film-thickness is insufficient by coating once. Suitable for the multi-layer coating are an extrusion method and a slide-hopper method. When a multi-layer coating is carried out, multi-layers may be coated at the same time, or alternatively they may be coated one over the other from several times to ten-several times. In the latter case, a screen method is also preferably used.

Generally, in the case where the thickness of the semiconductor fine particle layer, same as the thickness of the photosensitive layer, becomes thicker, the amount of the dye incorporated therein per unit of the projected area increases, thereby making the light capturing rate higher. However, because a diffusion distance of the generated electrons increases in the case, a loss owing to recombination of electric charges also increases. Consequently, a preferable thickness of the semiconductor fine particle layer is 0.1 to 100 µm.
When the semiconductor fine particle layer is utilized for the photo-electrochemical cell, the thickness thereof is preferably 1 to 30 µm, more preferably 2 to 25 µm. A coating amount of the semiconductor fine particles per 1 m² of the support is preferably 0.5 to 400 g, more preferably 5 to 100 g.

After coating the semiconductor fine particles on the conductive support, the particles are preferably subjected to a heat treatment to electronically contact them with each other, and to increase a coating strength and an adherence thereof with the support. A heating temperature is preferably 40 °C or more but less than 700 °C, more preferably 100 to 600 °C. A heating time is approximately 10 minutes to 10 hours. It is not preferred that a support having a low melting point or softening point such as a polymer film is subjected to a high temperature treatment because such a support tends to be deteriorated thereby. The heat treatment is preferably carried out at a temperature as low as possible also from a viewpoint of cost. The practice at such a low temperature is realized by a combination use with the above-described small semiconductor fine particles having a size of 5 nm or less, a heat treatment in the presence of a mineral acid, etc.

After a heat treatment, a chemical metal-plating using an titanium tetrachloride aqueous solution, etc. or an electrochemical metal-plating using an titanium trichloride aqueous solution may be carried out to increase a surface area of the semiconductor fine particles, or to enhance a purity in the vicinity of the particles, thereby improving an efficiency of electron injection into the particles from the dye.

It is preferable that the semiconductor fine particles have a large surface area, so that they can adsorb lots of dyes. Therefore, the surface area in the state that the semiconductor fine particle layer have been coated on the support is preferably 10 times or more, more preferably 100 times or more of the projected area. The highest limit, even though it is not limited in particular, is generally a level of 1000 times.

### (3) Dye

The dye used for the photosensitive layer in the present invention is preferably a metal complex dye, a phthalocyanine dye and/or a methine dye, more preferably a metal complex dye and/or a methine dye. Two or more kinds of dyes may be used as a mixture to obtain a large photoelectric conversion wavelength region and a high photoelectric conversion efficiency. In the case of using a plurality of the dyes as a mixture, the dye and its mixing ratio may be selected in accordance with the wavelength region and the strength distribution of the light source.

The dye preferably has an appropriate interlocking group for interacting with the surface of the semiconductor fine particles. Preferred interlocking groups include -COOH, -OH, -SO₃H, a cyano group, -P(O)(OH)₂, -OP(O)(OH)₂, and chelating groups with π-conductivity such as oxime, dioxime, hydroxyquinoline, salicylate and α-ketoenolate groups. Among them, particularly preferred are -COOH, -P(O)(OH)₂ and -OP(O)(OH)₂. The interlocking group may form a salt with an alkali metal, etc. or an intramolecular salt. If the methine chain of the polymethine dye has an acidic group as in the case where the methine chain forms a squarylium ring or a croconium ring, it may act as the interlocking group.

The preferred dyes used for the photosensitive layer will be specifically described below.

### (a) Metal Complex Dye

The metal complex dye used in the present invention is preferably ruthenium complex. The ruthenium complex dyes described in United States Patent Nos. 4,927,721, 4,684,537, 5,084,365, 5,350,644, 5,463,057, 5,525,440, Japanese Patent Laid-Open No. 7-249790, WO 98/50393, etc. may be used in the present invention.

The ruthenium complex dye is preferably represented by the following formula (I):

(A₁)ₚRu(B-a)(B-b)(B-c) (I)

wherein A₁ represents a ligand of SCN; *p* represents an integer of 2; and B-a, B-b and without B-c represent an organic ligand represented by the following formula B-1.

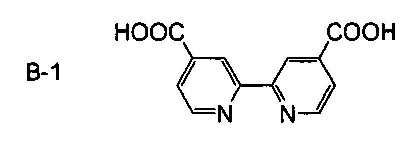

The metal complex dyes useful in the present invention will be illustrated below without intention of restricting the scope of the present invention defined by the claims attached hereto.

(A₁)ₚRu(B-a)(B-b)(B-c) (I),

| R | A₁ | p | B-a | B-b | B-c | R₁₁ |
|---|---|---|---|---|---|---|
| R-1 | SCN | 2 | B-1 | B-1 | - | - |

### (b) Methine Dye

The methine dyes preferably used in the present invention include those represented by any of the following general formulae (II), (III), (IV) and (V).

### 1. General Formula (II)

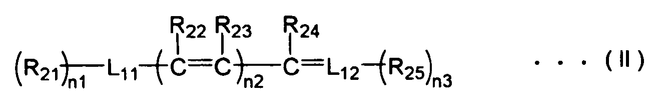

In the general formula (II), R₂₁ and R₂₅ independently represent a hydrogen atom, an alkyl group, an aryl group or a heterocyclic group; R₂₂ to R₂₄ independently represent a hydrogen atom or a substituent; R₂₁ to R₂₅ may be bonded together to form a ring; L₁₁ and L₁₂ independently represent a nitrogen atom, an oxygen atom, a sulfur atom, a selenium atom or a tellurium atom; n 1 and n3 independently represent an integer of 0 to 2; and n2 represents an integer of 1 to 6. This dye may have a counter ion in agreement with the charge quantity of the whole molecule.

The above-mentioned alkyl group, aryl group and heterocyclic group may have a substituent. The alkyl group may be a straight or branched, and the aryl group and the heterocyclic group may have a monocyclic structure or a polycyclic structure such as a condensed ring and a ring assemblage. Further, the ring formed by R₂₁ to R₂₅ may have a substituent, and may be a monocyclic ring or a condensed ring.

### 2. General Formula (III)

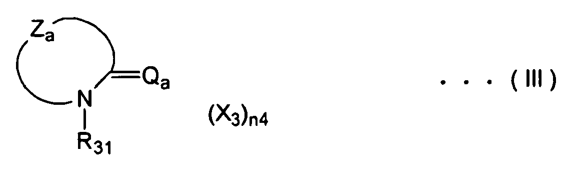

In the general formula (III), Zₐ represents a non-metal atomic group forming a nitrogen-containing heterocyclic group, and R₃₁ represents an alkyl group or an aryl group. Qₐ represents a methine group or a polymethine group necessary to act as a polymethine dye. The dye may form an oligomer or a polymer through Qₐ. X₃ represents a counter ion, and n4 indicating a number thereof represents an integer of 0 to 10.

The nitrogen-containing heterocyclic ring formed by Zₐ may have a substituent, and may be a monocyclic ring or a condensed ring. The alkyl or aryl group represented by R₃₁ may have a substituent, the alkyl group may be a straight or branched, and the aryl group may have a monocyclic structure or a polycyclic structure such as a condensed ring and a ring assemblage.

Of the dyes represented by the general formula (III), more preferred are those represented by any of the following general formulae (III-a) to (III-d): 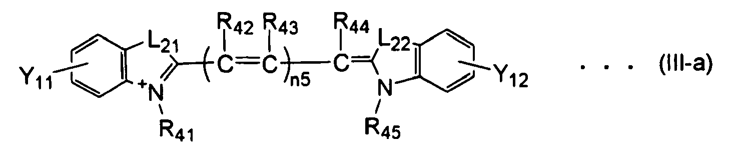 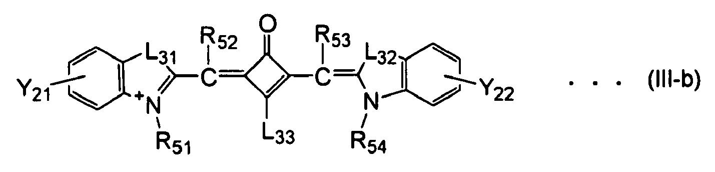 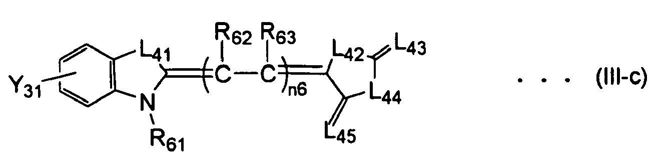 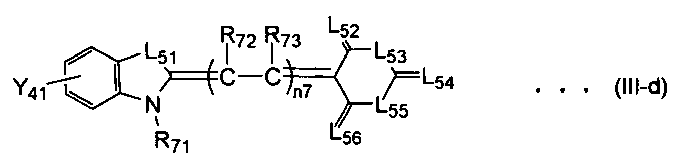 wherein R₄₁ to R₄₅, R₅₁ to R₅₄, R₆₁ to R₆₃ and R₇₁ to R₇₃ independently represent a hydrogen atom, an alkyl group, an aryl group or a heterocyclic group; L₂₁, L₂₂, L₃₁, L₃₂, L₄₁ to L₄₅ and L₅₁ to L₅₆ independently represent an oxygen atom, a sulfur atom, a selenium atom, a tellurium atom, -CRR'- or -NR- (in which R and R' independently represent a hydrogen atom, an alkyl group, an aryl group or a heterocyclic group, and may be the same or different); L₃₃ represents O⁻, S⁻, Se⁻, Te⁻ or N⁻R (in which R represents a hydrogen atom, an alkyl group, an aryl group or a heterocyclic group); Y₁₁, Y₁₂, Y₂₁, Y₂₂, Y₃₁ and Y₄₁ independently represent a substituent; and n5, n6, and n7 independently represent an integer of 1 to 6.

The dyes represented by any one of the general formulae (III-a) to (III-d) may have a counter ion in agreement with the charge of the molecule. The alkyl group, the aryl group and the heterocyclic group mentioned above may have a substituent, the alkyl group may be straight or branched, and the aryl group and the heterocyclic group may have a monocyclic structure or a polycyclic structure such as a condensed ring and a ring assemblage.

Specific examples of the polymethine dyes represented by the general formula (III) are described in detail in M. Okawara, T. Kitao, T. Hirashima and M. Matsuoka, Organic Colorants, Elsevier, etc.

### 3. General Formula (IV)

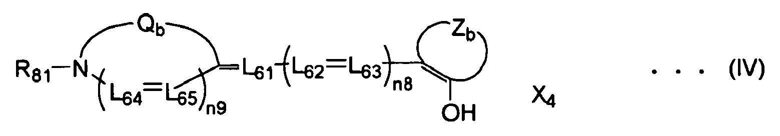

In the general formula (IV), Q_{b} represents an atomic group forming a 5- or 6-membered nitrogen-containing heterocycle; Z_{b} represents an atomic group forming a 3- to 9-membered ring; and L₆₁ to L₆₅ independently represent a substituted or unsubstituted methine group. n8 is an integer of 0 to 4, preferably 0 to 3, and n9 is 0 or 1. R₈₁ represents a substituent, and X₄ represents a counter ion contained if necessary to neutralize charge of the dye.

The nitrogen-containing heterocycle formed by Q_{b} may be a condensed ring, and may have a substituent. Preferable examples of the heterocycle include a benzothiazole ring, a benzoxazole ring, a benzoselenazole ring, a benzotellurazole ring, a 2-quinoline ring, a 4-quinoline ring, a benzoimidazole ring, a thiazoline ring, an indolenine ring, an oxadiazole ring, a thiazole ring and an imidazole ring. Of these, a benzothiazole ring, a benzoxazole ring, a benzoimidazole ring, a benzoselenazole ring, a 2-quinoline ring, a 4-quinoline ring and an indolenine ring are more preferred, a benzothiazole ring, a benzoxazole ring, a 2-quinoline ring, a 4-quinoline ring and an indolenine ring are particularly preferred.

Preferable examples of the substituent on Q_{b} include: a carboxyl group; a phosphonyl group; a sulfonyl group; halogen atoms such as F, Cl, Br and I; a cyano group; an alkoxy group such as a methoxy group, an ethoxy group and a methoxyethoxy group; an aryloxy group such as a phenoxy group; an alkyl group such as a methyl group, an ethyl group, a cyclopropyl group, a cyclohexyl group, a trifluoromethyl group, a methoxyethyl group, an allyl group and a benzyl group; an alkylthio group such as a methylthio group and an ethylthio group; an alkenyl group such as a vinyl group and a 1-propenyl group; an aryl group such as a phenyl group, a chlorophenyl group and toluyl group; a heterocyclic group such as a thienyl group; etc.

Z_{b} is preferably composed of atoms selected from the group consisting of carbon, oxygen, nitrogen, sulfur and hydrogen atoms. The ring formed by Z_{b} is preferably a ring with a 4 to 6 carbon skeleton, more preferably such that represented by any one of the following (a) to (e), the most preferably such that represented by (a).

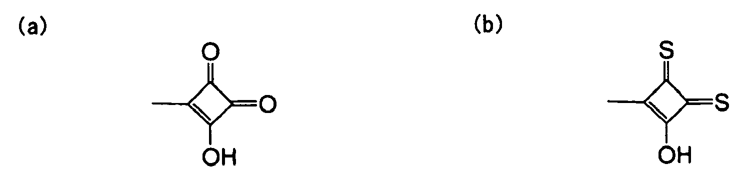

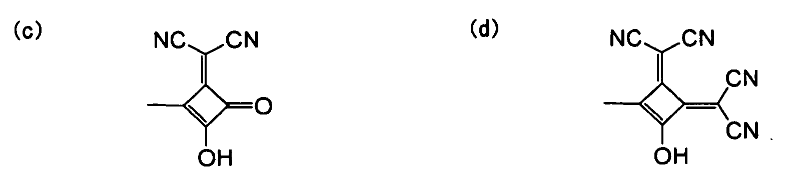

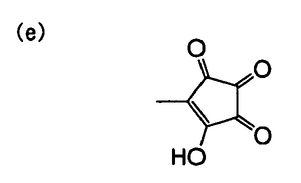

Examples of the substituent on L₆₁ to L₆₅ include: a substituted or unsubstituted alkyl group having preferably 1 to 12, more preferably 1 to 7 carbon atom, such as a methyl group, an ethyl group, a propyl group, an isopropyl group, a cyclopropyl group, a butyl group, a 2-carboxyethyl group and a benzyl group; a substituted or unsubstituted aryl group preferably having 6, 8 or 10 carbon atoms, more preferably 6 or 8 carbon atoms, such as a phenyl group, a tolyl group, a chlorophenyl group and an *o*-carboxyphenyl group; a heterocyclic group such as a pyridyl group, a thienyl group, a furanyl group and a barbituric acid group; a halogen atom such as a chlorine atom and a bromine atom; an alkoxy group such as a methoxy group and an ethoxy group; an amino group having preferably 1 to 12, more preferably 6 to 12 carbon atoms, such as a diphenylamino group, a methylphenylamino group and a 4-acetylpiperazine-1-yl group; an oxo group; etc. The substituents may be bonded together to form a cyclopentene ring, a cyclohexene ring, a squalilium ring, etc. Further, the substituents may combine an auxochrome to form a ring.

The substituent represented by R₈₁ is preferably an aliphatic group that may have a substituent or an aromatic group that may have a substituent. The aliphatic group has preferably 1 to 10, more preferably 1 to 6 carbon atom. The aromatic group has preferably 1 to 16 carbon atom, more preferably 5 or 6 carbon atoms. Examples of the unsubstituted aliphatic group and aromatic group include a methyl group, an ethyl group, a *n*-propyl group, a *n*-butyl group, a phenyl group and a naphthyl group.

Whether the dye is a cation or an anion and whether it has the net ionic charge or not depends on the auxochrome and substituents thereof. The charge of the whole dye molecule is neutralized by a counter ion X₄. Typical positive counter ions are inorganic or organic ammonium ions such as a tetraalkyl ammonium ion, a pyridinium ion, etc. and alkali metal ions. On the other hand, negative counter ions may be inorganic or organic, and examples thereof include: a halide ion such as a fluoride ion, a chloride ion, a bromide ion and an iodide ion; a substituted aryl sulfonate ion such as a *p*-toluene sulfonate ion and a *p*-chlorobenzene sulfonate ion; an aryl disulfonate ion such as a 1,3-benzene disulfonate ion, a 1,5-naphthalene disulfonate ion and a 2,6-naphthalene disulfonate ion; an alkyl sulfate ion such as a methyl sulfate ion; a sulfate ion; a thiocyanate ion; a perchlorate ion; a tetrafluoroborate ion; a picrate ion; an acetate ion; a trifluoromethane sulfonate ion; etc.

Further, ionic polymers or other dyes having an opposite charge to the dye may be also used as a charge-balancing counter ion. Alternatively metal complex such as bisbenzene-1,2-dithiolato nickel (III) can be also used in the present invention.

### 4. General Formula (V)

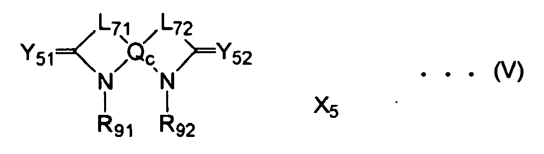

In the general formula (V), Q_{c} represents an at least tetravalent aromatic group; and L₇₁ and L₇₂ independently represent a sulfur atom, a selenium atom or -CRR'- (R and R' independently represent a hydrogen atom or an alkyl group). L₇₁ and L₇₂ are preferably a sulfur atom or -CRR'-, more preferably -CRR'-, respectively. R₉₁ and R₉₂ independently represent an alkyl group or an aromatic group, and Y₅₁ and Y₅₂ independently represent a non-metal atomic group necessary to act as a polymethine dye. X₅ represents a counter ion.

Examples of Q_{c} include at least tetravalent aromatic groups derived from: an aromatic hydrocarbon such as benzene, naphthalene, anthracene and phenanthrene; or an aromatic heterocyclic ring such as anthraquinone, carbazole, pyridine, quinoline, thiophene, furan, xanthene and thianthrene. The aromatic group may have a substituent. Q_{c} is derived from preferably aromatic hydrocarbon, more preferably benzene or naphthalene.

Various kinds of methine dyes can be formed by Y₅₁ and Y₅₂. It is preferably that Y₅₁ and Y₅₂ form a cyanine dye, a merocyanine dye, a rhodacyanine dye, a trinuclear merocyanine dye, an allopolar dye, a hemicyanine dye or a styryl dye. Herein, the cyanine dyes include such that having substituents on the methine chain forming a squalium ring, a croconium ring, etc. Details of the dyes represented by the general formula (V) are described in: F. M. Harmer, "Heterocyclic Compounds -Cyanine Dyes and Related Compounds", John Wiley & Sons, New York, London (1964); D. M. Sturmer, "Heterocyclic Compounds -Special Topics in Heterocyclic Chemistry", chapter 18, section 14, pp. 482 to 515, John Wiley & Sons, New York, London (1977); etc. Preferred examples of the cyanine dyes, the merocyanine dyes and the rhodacyanine dyes include those described in United States Patent No. 5,340,694, chapter (XI), (XII) and (XIII), pp. 21 to 22. The dye represented by the general formula (V) has a squalilium ring on preferably at least one methine chain, more preferably the both methine chains.

R₉₁ and R₉₂ are independently an alkyl group or an aromatic group, and may have a substituent. The aliphatic group has preferably 1 to 10 carbon atom, more preferably 1 to 6 carbon atom. The aromatic group has preferably 5 to 16 carbon atoms, more preferably 5 or 6 carbon atoms. Examples of the unsubstituted aliphatic group and aromatic group include a methyl group, an ethyl group, a *n*-propyl group, a *n*-butyl group, a phenyl group and a naphthyl group.

It is preferable that at least one of R₉₁, R₉₂, Y₅₁ and Y₅₂ has an acidic group. The acidic group is a group with a dissociative proton, such as a carboxylic acid group, a phosphonic acid group, a sulfonic acid group, a boric acid group, etc. Among them, preferred is a carboxylic acid group. The dissociative proton of the acidic group may be dissociated.

The specific examples (1) to (43) and S-1 to S-42 of the polymethine dyes represented by the general formulae (II) to (V) will be illustrated below without intention of restricting the scope of the present invention defined by the claims attached hereto.

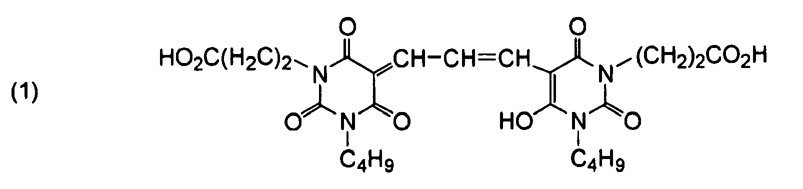

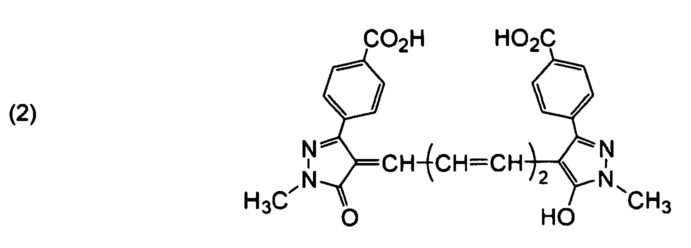

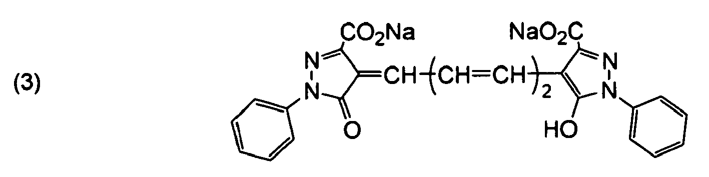

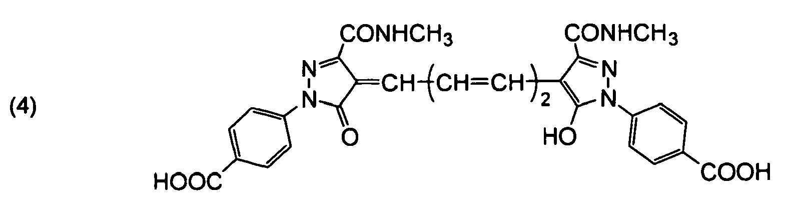

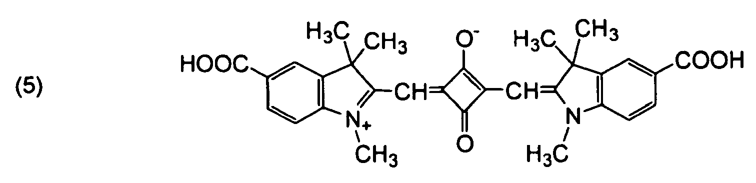

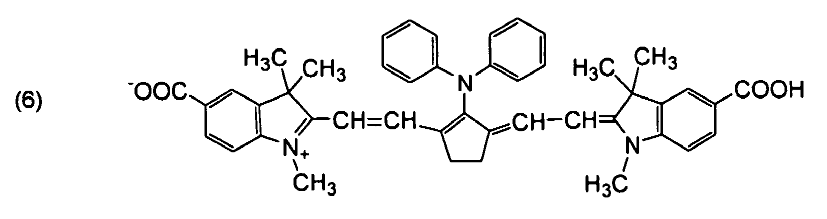

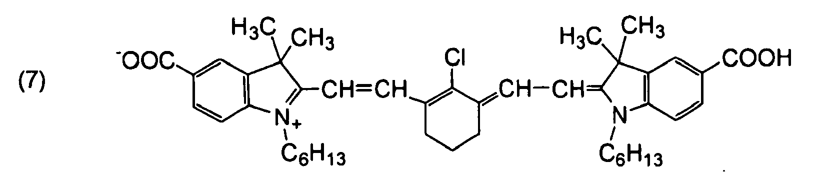

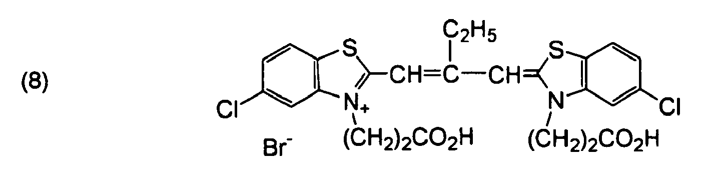

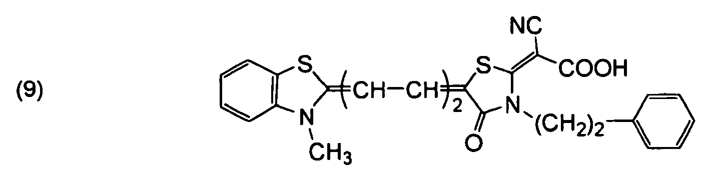

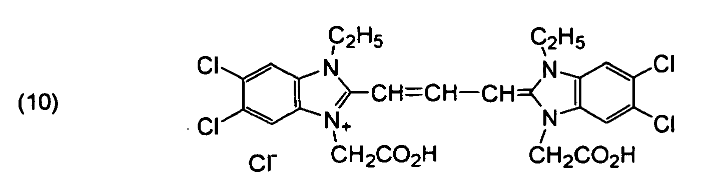

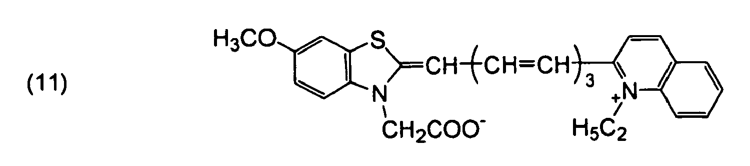

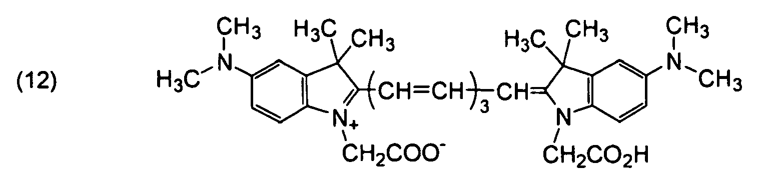

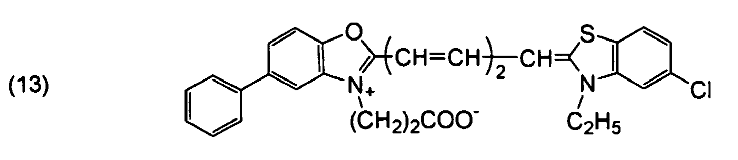

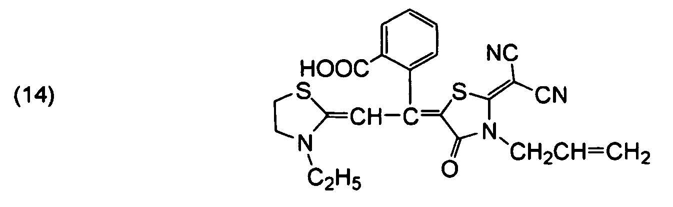

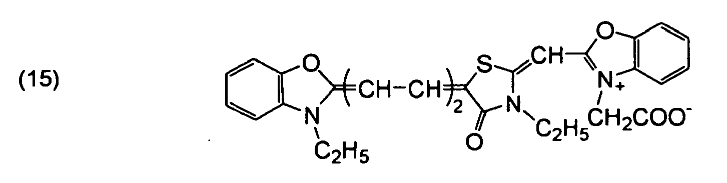

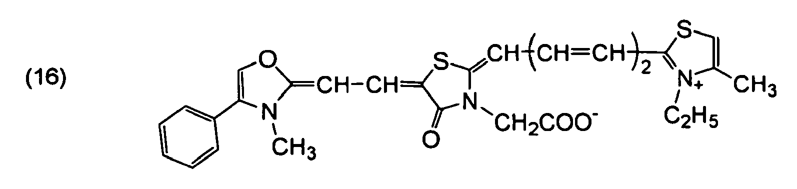

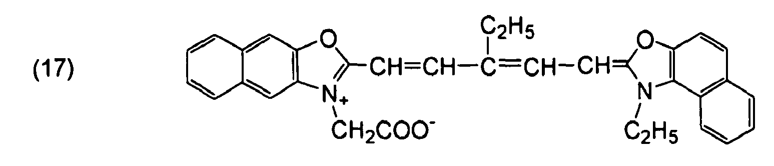

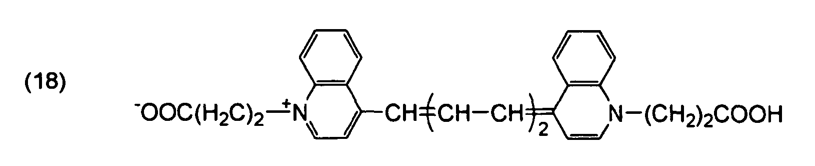

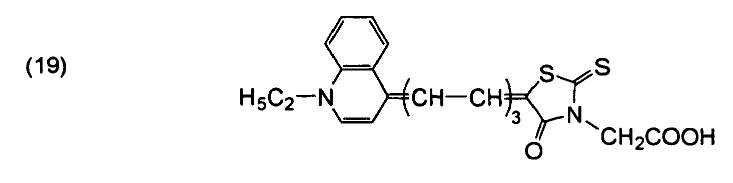

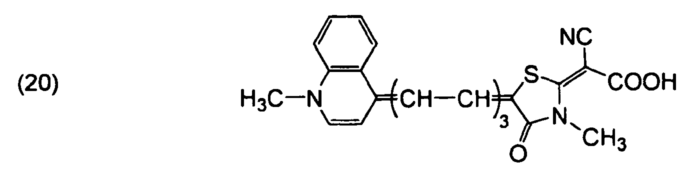

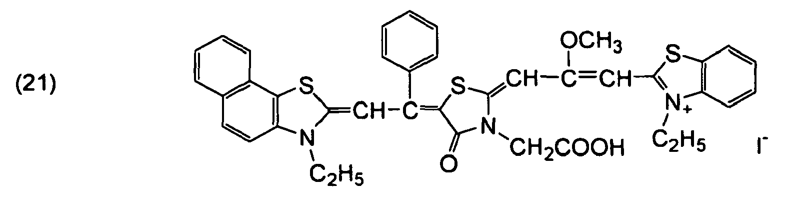

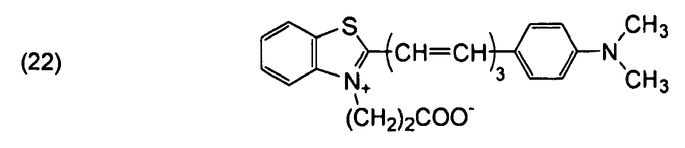

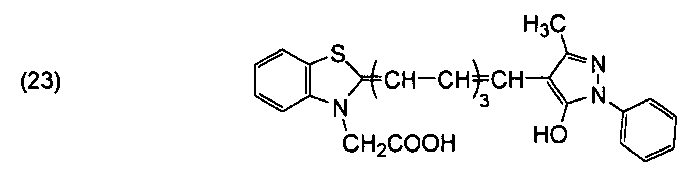

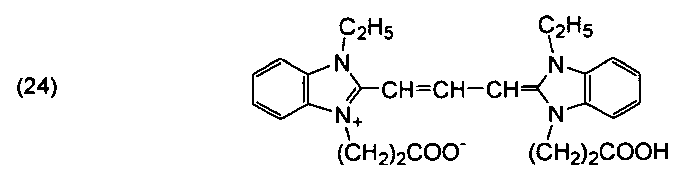

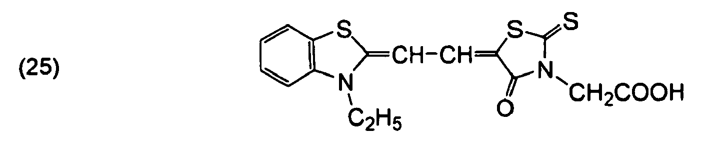

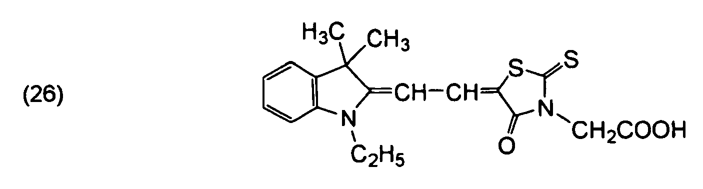

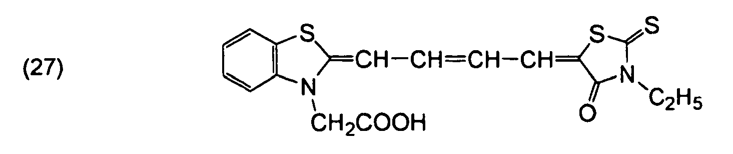

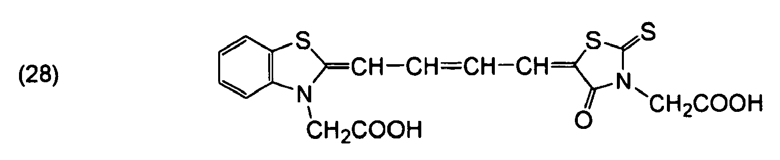

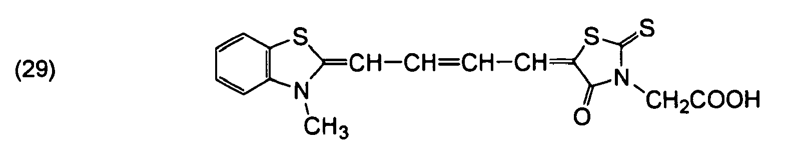

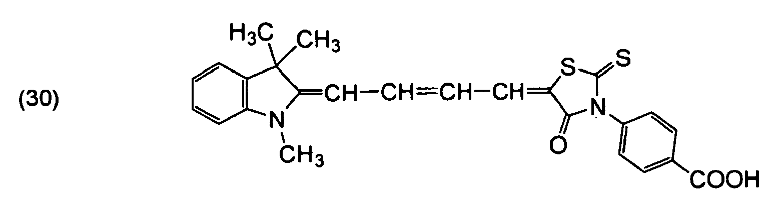

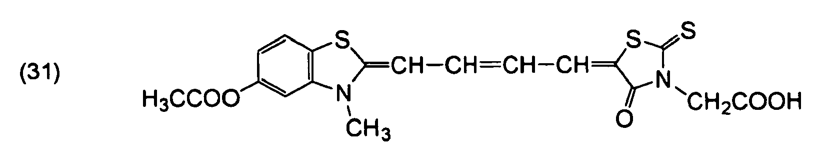

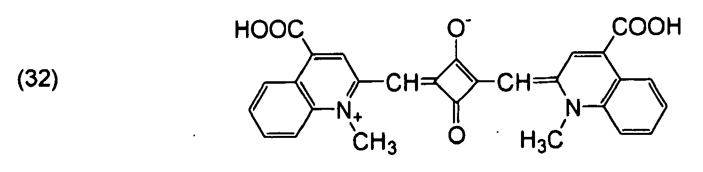

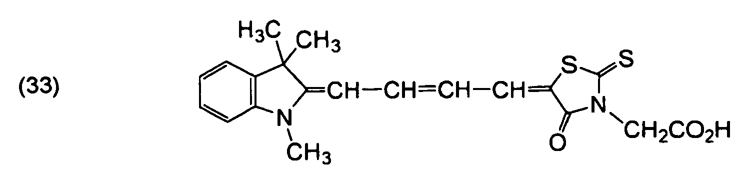

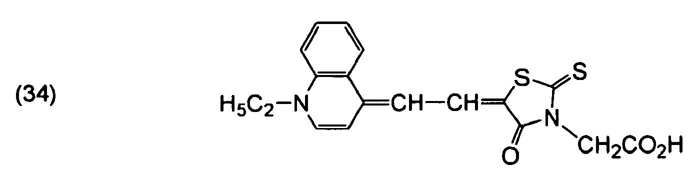

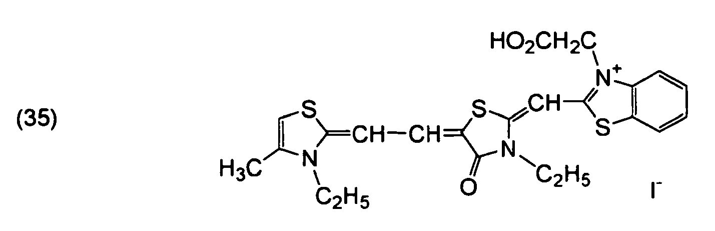

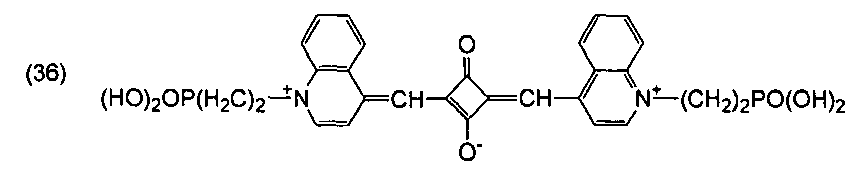

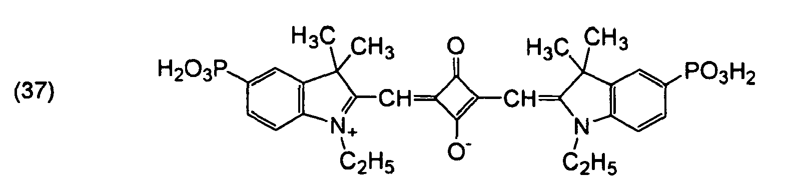

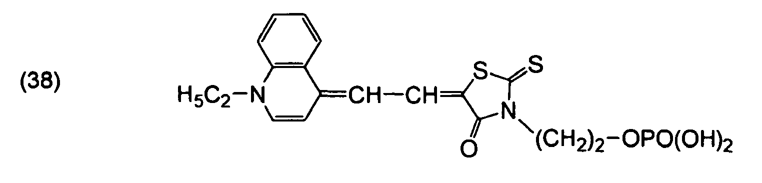

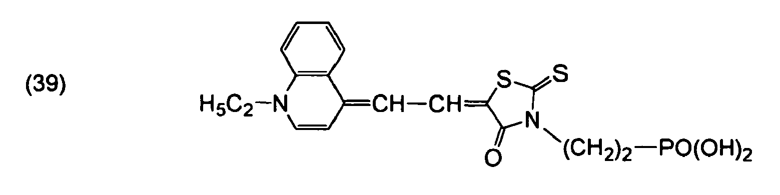

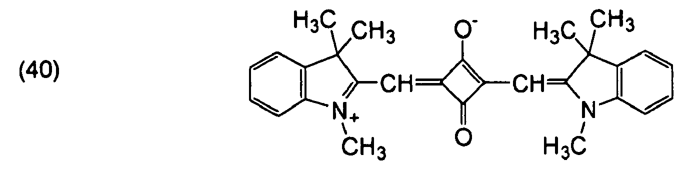

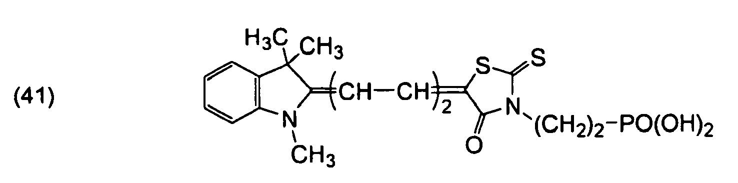

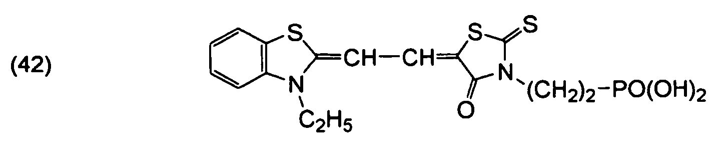

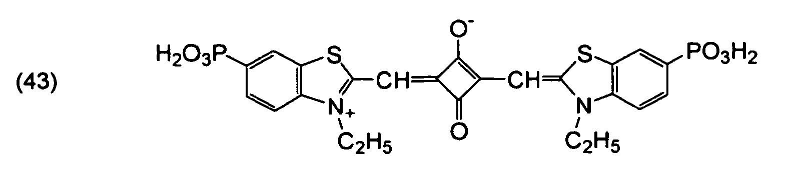

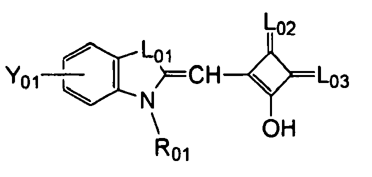

| Dye | Y₀₁ | R₀₁ | L₀₁ | L₀₂ | L₀₃ |
|---|---|---|---|---|---|
| S-1 | 4,5-Benzo | C₃H₇ | C(CH₃)₂ | O | O |
| S-2 | H | (CH₂)₃COOH | C(CH₃)₂ | O | O |
| S-3 | 4,5-Benzo | C₂H₅ | C(CH₃)₂ | S | S |
| S-4 | 4,5-Benzo | C₂H₅ | C(CH₃)₂ | C(CN)₂ | O |
| S-5 | 4,5-Benzo | C₂H₅ | C(CH₃)₂ | C(CN)₂ | C(CN)₂ |
| S-6 | H | C₂H₅ | S | O | O |
| S-7 | 4,5-Benzo | CH₃ | S | O | O |
| S-8 | H | CH₃ | O | O | O |
| S-9 | H | CH₃ | Se | O | O |
| S-10 | H | CH₃ | N(C₂H₅) | O | O |
| S-11 | H | C₂H₅ | -CH=CH- | O | O |

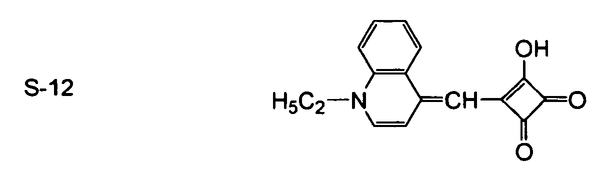

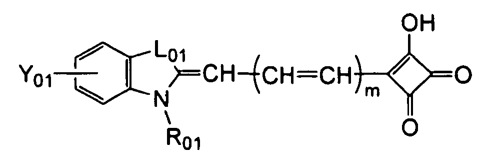

| Dye | Y₀₁ | R₀₁ | L₀₁ | m |
|---|---|---|---|---|
| S-13 | H | CH₃ | C(CH₃)₂ | 1 |
| S-14 | 4,5-Benzo | C₂H₅ | C(CH₃)₂ | 1 |
| S-15 | H | CH₃ | S | 2 |
| S-16 | 4,5-Benzo | C₂H₅ | S | 3 |
| S-17 | 4,5-Benzo | C₂H₅ | S | 4 |
| S-18 | H | CH₃ | O | 1 |

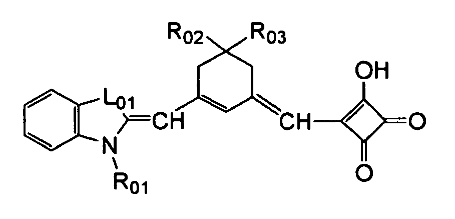

| Dye | R₀₁ | R₀₂ | R₀₃ | L₀₁ |
|---|---|---|---|---|
| S-19 | C₂H₅ | CH₃ | CH₃ | C(CH₃)₂ |
| S-20 | C₂H₅ | CH₃ | CH₃ | S |
| S-21 | (CH₂)₃COOH | CH₃ | CH₃ | O |
| S-22 | C₂H₅ | Ph | H | O |

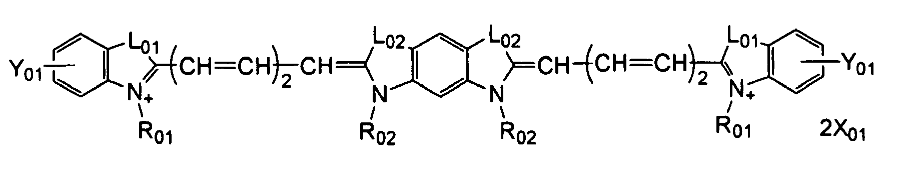

| Dye | Y₀₁ | R₀₁ | R₀₂ | L₀₁ | L₀₂ | X₀₁ |
|---|---|---|---|---|---|---|
| S-23 | H | CH₃ | CH₃ | S | S | I⁻ |
| S-24 | 5-COOH | C₂H₅ | CH₃ | S | S | I⁻ |
| S-25 | 5-COOH | CH₃ | CH₃ | C(CH₃)₂ | C(CH₃)₂ | I⁻ |
| S-26 | H | (CH₂)₂COOH | C₂H₅ | C(CH₃)₂ | C(CH₃)₂ | Cl⁻ |
| S-27 | H | CH₃ | C₂H₅ | C(CH₃)₂ | O | I⁻ |

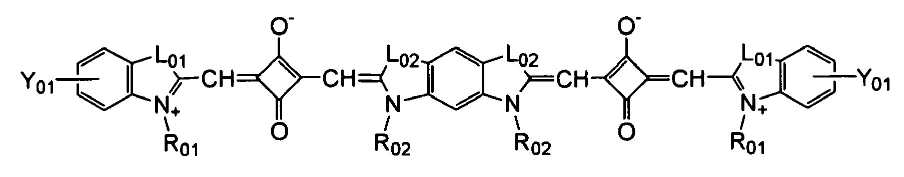

| Dye | Y₀₁ | R₀₁ | R₀₂ | L₀₁ | L₀₂ |
|---|---|---|---|---|---|
| S-28 | H | CH₃ | CH₃ | C(CH₃)₂ | S |
| S-29 | 4,5-Benzo | C₃H₇ | CH₃ | C(CH₃)₂ | S |
| S-30 | 5-COOH | CH₃ | CH₃ | S | C(CH₃)₂ |
| S-31 | 5-COOH | CH₃ | CH₃ | C(CH₃)₂ | C(CH₃)₂ |
| S-32 | 5-CH₃ | CH₃ | C₂H₅ | N(CH₃) | C(CH₃)₂ |

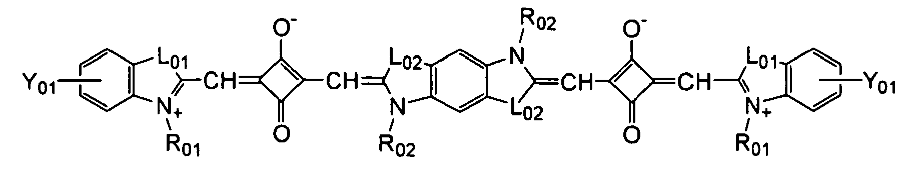

| Dye | Y₀₁ | R₀₁ | R₀₂ | L₀₁ | L₀₂ |
|---|---|---|---|---|---|
| S-33 | H | CH₃ | CH₃ | C(CH₃)₂ | S |
| S-34 | 5-SO₃H | C₂H₅ | CH₃ | C(CH₃)₂ | S |
| S-35 | 5-COOH | CH₃ | C₂H₅ | C(CH₃)₂ | C(CH₃)₂ |
| S-36 | 4,5-Benzo | (CH₂)₂COOH | CH₃ | C(CH₃)₂ | C(CH₃)₂ |
| S-37 | 5-CH₃ | CH₃ | C₂H₅ | NCH₃ | C(CH₃)₂ |

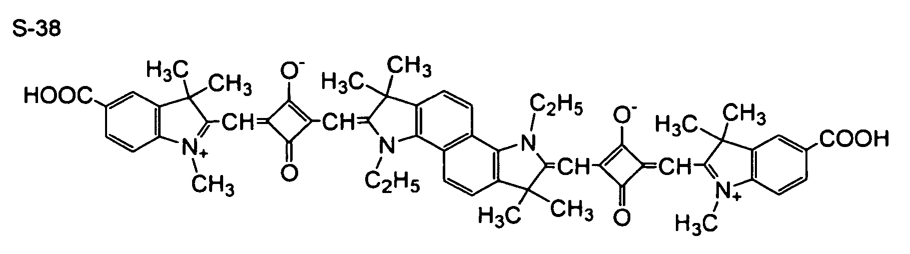

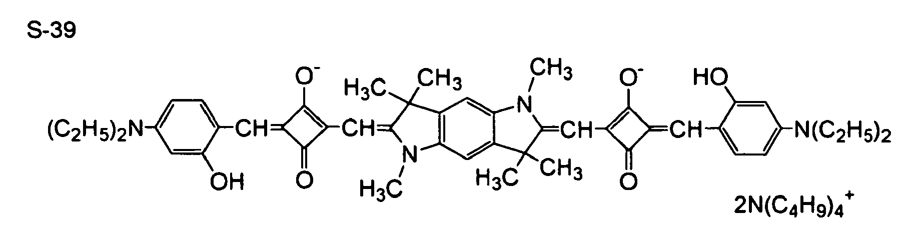

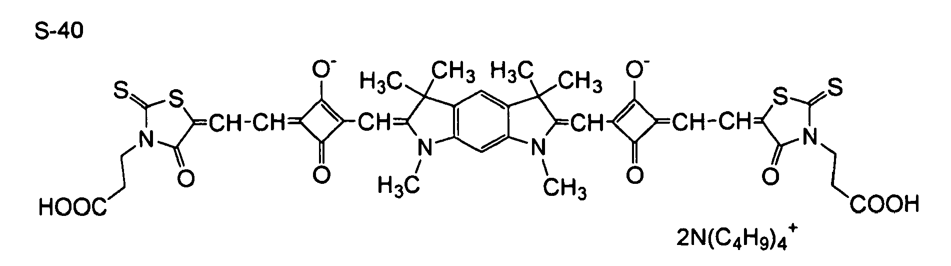

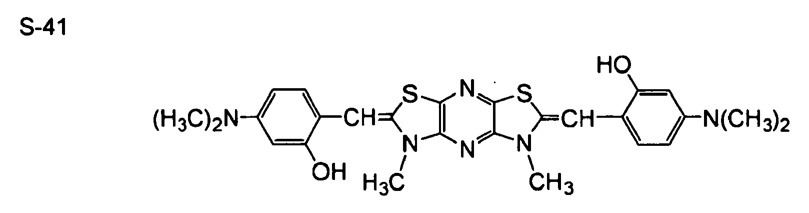

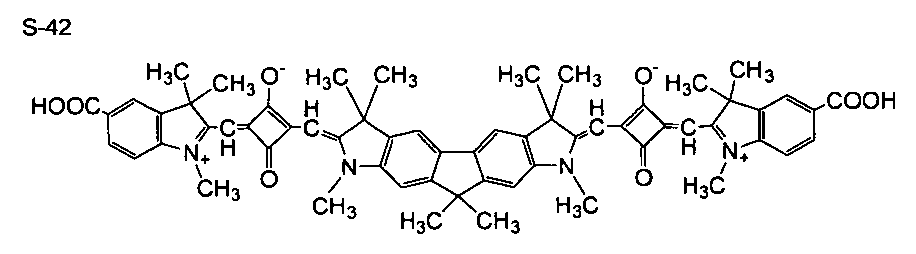

The dyes represented by the formulae (II) and (III) can be synthesized by the methods described in: F. M. Harmer, "Heterocyclic Compounds -Cyanine Dyes and Related Compounds", John Wiley & Sons, New York, London (1964); D. M. Sturmer, "Heterocyclic Compounds -Special Topics in Heterocyclic Chemistry", chapter 18, section 14, pp. 482 to 515, John Wiley & Sons, New York, London (1977); "Rodd's Chemistry of Carbon Compounds", 2nd. Ed., vol. IV, part B, chapter 15, pp. 369 to 422, Elsevier Science Publishing Company Inc., New York (1977); British Patent No. 1,077,611; etc. The dyes represented by the formula (IV) can be synthesized based on the methods described in Dyes and Pigments, vol. 21, pp. 227 to 234, etc. The dyes represented by the formula (V) can be synthesized based on: Ukrainskii Khimicheskii Zhurnal, vol. 40, No. 3, pp. 253 to 258; Dyes and Pigments, vol. 21, pp. 227 to 234; and references therein.

### (4) Adsorption of Dye to Semiconductor Fine Particles

The dye may be adsorbed to the semiconductor fine particles by soaking the conductive support having the well-dried semiconductor fine particle layer in a dye solution, or by coating the dye solution to the semiconductor fine particle layer. In the former case, a soaking method, a dipping method, a roller method, an air-knife method, etc. may be used. In the case of the soaking method, the dye may be adsorbed at a room temperature or while refluxing as described in Japanese Patent Laid-Open No. 7-249790. As a coating method of the latter, a wire-bar method, a slide-hopper method, an extrusion method, a curtain method, a spin method, a spray method, etc. may be used. As a printing method, a relief printing, an offset printing, a gravure printing, a screen-printing, etc. may be used.

A solvent for the dye solution may be properly selected in accordance with the solubility of the dye. For example, alcohols such as methanol, ethanol, *t*-butanol, benzyl alcohol, etc.; nitriles such as acetonitrile, propionitrile, 3-methoxypropionitrile, etc.; nitromethane; halogenated hydrocarbons such as dichloromethane, dichloroethane, chloroform, chlorobenzene, etc.; ethers such as diethylether, tetrahydrofuran, etc.; dimethylsulfoxide; amides such as *N,N-*dimethylformamide, *N,N*-dimethylacetamide, etc.; *N*-methylpyrrolidone; 1,3-dimethylimidazolidinone; 3-methyloxazolidinone; esters such as ethyl acetate, butyl acetate, etc.; carbonates such as diethyl carbonate, ethylene carbonate, propylene carbonate, etc.; ketones such as acetone, 2-butanone, cyclohexanone, etc.; hydrocarbons such as hexane, petroleum ether, benzene, toluene, etc.; and mixtures thereof may be used.

As is similar to the case of forming the semiconductor fine particle layer, an extrusion method and various kinds of printing methods are suitable for a high viscosity solution (e.g. 0.01 to 500 Poise), and a slide-hopper method, a wire bar method and a spin method are suitable for a low viscosity solution (e.g. 0.1 Poise or less) to form a uniform film.

Thus, the dye adsorption method may be properly selected in accordance with the viscosity of the dye solution, the coating amount, the conductive support, the coating speed, etc. It is preferable that the dye-adsorbing time after coating is as short as possible from a viewpoint of mass production.

The unadsorbed dyes are preferably removed by washing immediately after adsorption because they often cause disturbance of efficiency of the device. The washing is preferably carried out using a wet-type washing bath with a polar solvent such as acetonitrile, or an organic solvent such as an alcohol-based solvent. To enhance the adsorption amount of the dye, a heat treatment is preferably carried out before the adsorption. After the heat treatment, it is preferable that the dye is quickly adsorbed at 40 to 80 °C without cooling to a room temperature in order to prevent adsorption of water to the surface of the semiconductor fine particles.

The total amount of the dye is preferably 0.01 to 100 mmol per the unit surface area (1 m²) of the conductive support. The amount of the dye adsorbed to the semiconductor fine particles is preferably 0.01 to 1 mmol per 1 g of the semiconductor fine particles. Such an adsorption amount of the dye effects a sufficient sensitization to the semiconductors. In contrast, if the amount of the dye is too small, the sensitization effect is not sufficient. On the other hand, if it is excessive, the dye unadsorbed to the semiconductor fine particles floats to reduce sensitization effect.

Two or more kinds of dyes may be mixed and used for the photoelectric conversion device to extend the conversion wavelength range and to increase a conversion efficiency. In this case, the dyes and their proportion are preferably selected in accordance with the wavelength region and the intensity distribution of a light source.

A colorless compound may be co-adsorbed on the semiconductor fine particles together with the dye to weaken an interaction, such as association, between the dyes. Used as a hydrophobic compound for the co-adsorption may be a steroid compound having a carboxyl group such as chenodeoxycholic acid, etc. An UV-absorbing agent may be used together therewith.

The surface of the semiconductor fine particles may be treated with amines after dye adsorption to accelerate to remove an excessive dye. Preferable examples of the amines include pyridine, 4-*t*-butylpyridine, polyvinylpyridine, etc. The amine may be used as it is, or as a solution with an organic solvent when it is liquid.

### (C) Charge Transfer Layer

The charge transfer layer replenishes electrons to the oxidized dye. The charge transfer layer comprises the electrolyte composition of the present invention mentioned above. A solid electrolyte and a hole-transporting material may be also used therefor.

The charge transfer layer is preferably formed by applying the electrolyte composition to the photosensitive layer using a casting method, a coating method, a soaking method, a loading method, etc., and heating if necessary.

In the case of the coating method, the charge transfer layer may be formed by: preparing the uniform solution of the electrolyte composition comprising the molten salt, additives such as a coating quality-improving agent (a leveling agent, etc.), etc.; coating the solution by a spin coating method, a dip coating method, an air-knife coating method, a curtain coating method, a roller coating method, a wire-bar coating method, a gravure coating method, an extrusion coating method using a hopper described in United States Patent No. 2,681,294, a simultaneous multi-layer coating method described in United States Patent Nos. 2,761,418, 3,508,947 and 2,761,791; and heating if necessary. The heating temperature is properly selected in accordance with a heat-resistance of the dye, etc. The temperature is preferably 10 to 150 °C, more preferably 10 to 100 °C in general. The heating time, depending on the heating temperature, etc., may be approximately 5 minutes to 72 hours.

According to the preferable embodiment of the present invention, the solution of the electrolyte composition is coated in an excess of the amount with which voids in the photosensitive layer are completely fulfilled. Therefore, the resulting electrolyte layer substantially exists from the surface of the electrically conductive layer 10 to the surface of the counter electrically conductive layer 40, as shown in Fig. 1. Herein, if the electrolyte layer is defined as the charge transfer layer 30, the thickness thereof is preferably 0.001 to 200 µm, more preferably 0.1 to 100 µm, particularly preferably 0.1 to 50 µm. When the charge transfer layer 30 has thickness of less than 0.001 µm, there is a fear that the semiconductor fine particles 21 in the photosensitive layer comes in contact with the counter electrically conductive layer 40. On the other hand, when the thickness is more than 200 µm, the charge transfer distance becomes too large, thereby increasing the resistance of the device. Incidentally, the total thickness of the photosensitive layer 20 and the charge transfer layer 30, which is substantially equal to the thickness of the electrolyte layer, is preferably 0.1 to 300 µm, more preferably 1 to 130 µm, particularly preferably 2 to 75 µm.

To form an oxidation-reduction pair in the electrolyte composition, iodine, etc. may be introduced by: adding it to the above-mentioned solution of the electrolyte composition; or placing the support disposed the charge transfer layer thereon in a sealed vessel with iodine, etc., thereby diffusing it into the electrolyte; etc. Further, iodine may be introduced to the charge transfer layer by coating or vapor-depositing it on the counter electrode before constituting the photoelectric conversion device.

### (D) Counter Electrode

When the photoelectric conversion device of the present invention is applied to the photoelectric cell, the counter electrode acts as an anode of the cell. The counter electrode may be a single layer of a counter conductive layer of an electrically conductive material, or composed of the counter electrically conductive layer and a support, as is similar to the above-described conductive support. Examples of the conductive material for the counter electrically conductive layer include: metals such as platinum, gold, silver, copper, aluminum, rhodium and indium; carbon; and electrically conductive metal oxides such as indium-tin composite oxides and fluorine-doped tin oxides. The substrate for the counter electrode is preferably made of glass or plastic, and the electrically conductive layer is coated or vapor-deposited thereon.

The thickness of the counter electrically conductive layer is not limited in particular, preferably 3 nm to 10 µm. In the case of the metal counter electrically conductive layer, the thickness thereof is preferably 5 µm or less, more preferably 5 nm to 3 µm.

A light may be irradiated from any one or both side of the conductive support and the counter electrode. At least one of them must be substantially transparent to have light reached to the photosensitive layer. From a viewpoint of improving an electric generation efficiency, it is preferably that the conductive support is transparent and light is irradiated through it. In this case, the counter electrode preferably has a light-reflective property. Glass or plastic having vapor-deposited metal or electrically conductive oxides thereon, or a metal thin film can be preferably used as a material for such a counter electrode.

The counter electrode may be disposed (i) on the charge transfer layer formed beforehand, or (ii) on the semiconductor fine particle layer through a spacer before forming the charge transfer layer. In the case of (i), the counter electrode may be disposed by: directly coating, metal-plating, or vapor-depositing (PVD, CVD, etc.) the electrically conductive material on the charge transfer layer; or laminating the electrically conductive layer formed on the substrate on the charge transfer layer. In the case of (ii), the counter electrode is disposed on the semiconductor fine particle layer through the spacer, and the open ends therebetween is soaked in the solution of the electrolyte composition. The solution penetrates into the voids between the counter electrode and the semiconductor fine particle layer by capillarity or reduced pressure.

Similar to the case of the conductive support, it is preferable to use the metal lead for reducing the resistance of the electrode particularly in the case of the transparent counter electrode. Preferable embodiments of the metal lead are the same as the case of the conductive support mentioned above.

### (E) Other Layers

Functional layers such as a protective layer and a reflection-preventing layer may be disposed on one or both of the conductive support and the counter electrode each acting as the electrode. Such functional layers may be formed in a fashion of multi-layers by a simultaneous multi-layer coating method or a successive coating method. Of these, the simultaneous multi-layer coating method is preferred from a viewpoint of productivity. As for the simultaneous multi-layer coating method, a slide-hopper method and an extrusion method are preferable from the viewpoint of the productivity and homogeneity of a coated film. The functional layers may be disposed by a method selected in accordance with the materials for the layer, such as a vapor-deposition method and a sticking method.

An undercoating layer may be disposed between the conductive support and the photosensitive layer to prevent short-circuit of the device. The undercoating layer is preferably composed of a semiconductor thin film. Preferable materials therefor include TiO₂, SnO₂, Fe₂O₃, WO₃, ZnO and Nb₂O₅. Among them, TiO₂ is more preferred. The undercoating layer may be disposed by a spray-pyrolysis method described in Electrochim. Acta, 40, 643 to 652 (1995). The thickness of the undercoating layer is preferably 5 to 1000 nm, more preferably 10 to 500 nm.

### (F) Interior Structure of Photoelectric Conversion Device

As described above, the photoelectric conversion device may have various interior structures in accordance with an end of use. These structures are classified into two major forms, a structure allowing incidence of light from both faces, and a structure allowing it from only one face. Fig. 2 to 8 each illustrate examples of the interior structure of the photoelectric conversion device that can be preferably used in the present invention.

As for the structure illustrated in Fig. 2, a photosensitive layer 20 and a charge transfer layer 30 are disposed between a transparent electrically conductive layer 10a and a transparent counter electrically conductive layer 40a. This structure allows incidence of a light from both faces of the device.

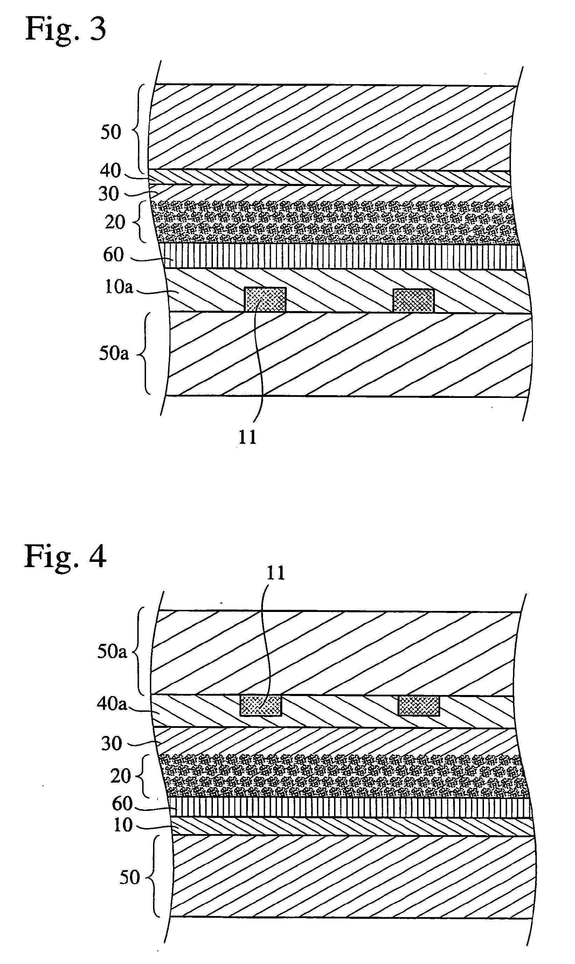

As for the structure illustrated in Fig. 3, on a transparent substrate 50a partially having a metal lead 11 is disposed a transparent electrically conductive layer 10a, an undercoating layer 60, a photosensitive layer 20, a charge transfer layer 30 and a counter electrically conductive layer 40 are laminated in this order, and a substrate 50 is further placed thereon. This structure allows incidence of light from the electrically conductive layer side.

As for the structure illustrated in Fig. 4, a photosensitive layer 20 is disposed on a substrate 50 having an electrically conductive layer 10 thereon through an undercoating layer 60, a charge transfer layer 30 and a transparent counter electrically conductive layer 40a are disposed thereon, and further a transparent substrate 50a locally having a metal lead 11 is placed so that the metal lead 11 side orients inward. This structure allows incidence of light from the counter electrode side.

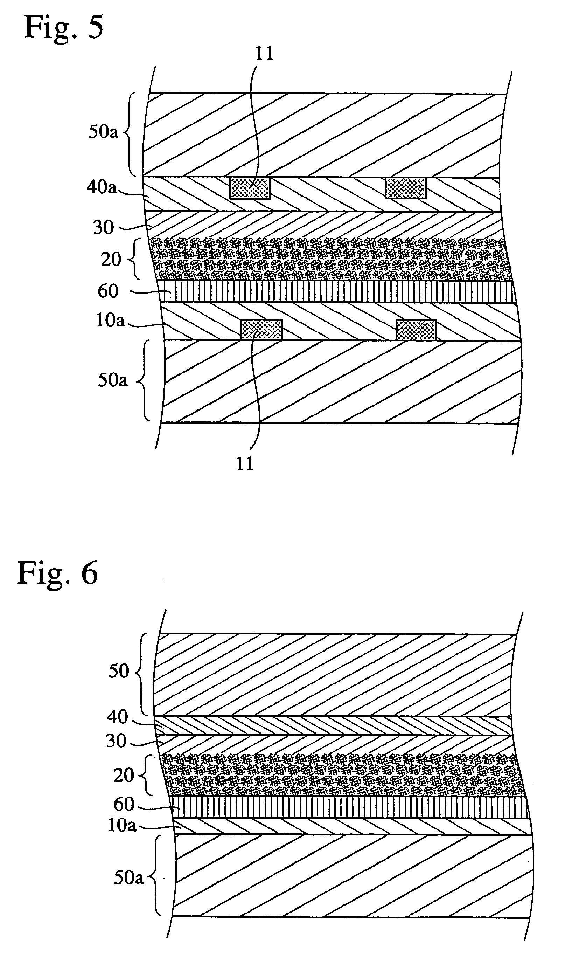

As for the structure illustrated in Fig. 5, on two transparent substrates 50a each having a metal lead 11 partially are formed a transparent electrically conductive layer 10a or a transparent counter electrically conductive layer 40a, respectively, and an undercoating layer 60, a photosensitive layer 20 and a charge transfer layer 30 placed between the conductive layers. This structure allows incidence of light from both faces of the photoelectric conversion device.

As for the structure illustrated in Fig. 6, on a transparent substrate 50a having a transparent electrically conductive layer 10a is disposed a photosensitive layer 20 through an undercoating layer 60, a charge transfer layer 30 and a counter electrically conductive layer 40 are formed thereon, and further a substrate 50 is placed thereon. This structure allows incidence of light from the electrically conductive layer side.

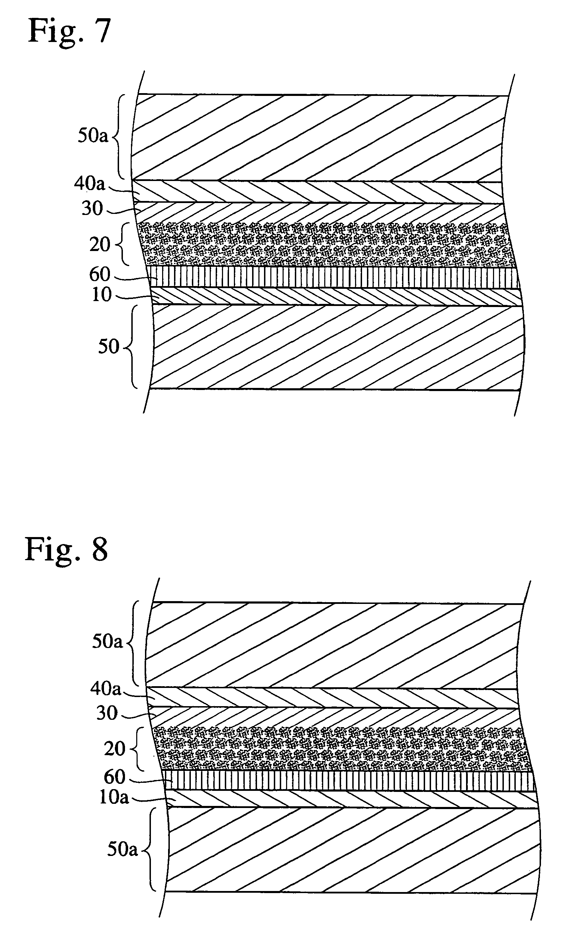

As for the structure illustrated in Fig. 7, on a substrate 50 having an electrically conductive layer 10 is disposed a photosensitive layer 20 through an undercoating layer 60, a charge transfer layer 30 and a transparent counter electrically conductive layer 40a are formed thereon, and further a transparent substrate 50a is placed thereon. This structure allows incidence of light from the counter electrode side.

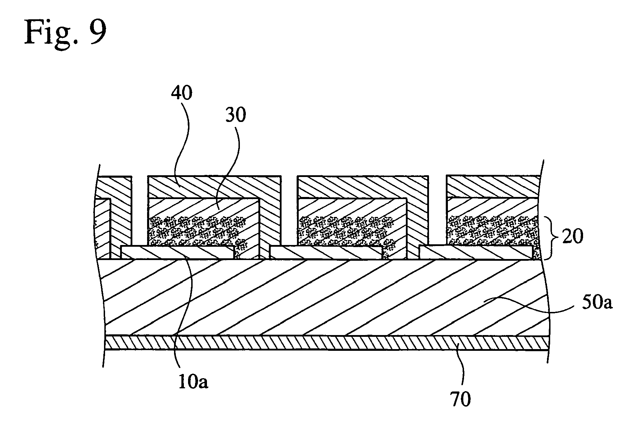

As for the structure illustrated in Fig. 8, on a transparent substrate 50a having a transparent electrically conductive layer 10a is disposed a photosensitive layer 20 through an undercoating layer 60, a charge transfer layer 30 and a transparent counter electrically conductive layer 40a are formed thereon, and further a transparent substrate 50a is placed thereon. This structure allows incidence of light from both faces of the photoelectric conversion device.

### [3] Photo-Electrochemical Cell

The photo-electrochemical cell of the present invention comprises the above-described photoelectric conversion device designed to work in the outer circuit. The side face of the photo-electrochemical cell is preferably sealed with a polymer or an adhesive agent, etc. to prevent deterioration of the compositions thereof and volatility of the content in the cell. The outer circuit is connected to the conductive support and the counter electrode via a lead. Various known circuits may be used in the present invention.

### [4] Dye-Sensitized Solar Cell

In the case where the photoelectric conversion device of the present invention is applied to a so-called solar cell, the interior structure of a cell may be essentially the same as the photoelectric conversion device mentioned above. Module structures of the solar cell comprising the photoelectric conversion device of the present invention will be explained below.

The dye-sensitized solar cell of the present invention may have the same module structure as that of prior art solar cells. The solar cell module generally has a structure where cells are placed on a substrate of metal, ceramic, etc., they are covered with a packing resin, a protective glass, etc., and light is introduced from an opposite side of the substrate. In addition, the solar cell module may have a structure where the cells are placed on a substrate of a transparent material such as a tempered glass, and light is introduced from the transparent substrate side. Specifically, a superstraight type module structure, a substrate type module structure, a potting type module structure, substrate-integrated type module structure used for an amorphous silicon solar cell, etc. are known as the solar cell module structure. The dye-sensitized solar cell of the present invention may have a module structure properly selected from the above structures in accordance with ends, environment at use.

The super straight type module and the substrate type module generally have a structure where the cells are placed at a regular intervals between substrates, and connected by a metal lead, a flexible wirering, etc., and collector electrodes are placed at the outer marginal portion so that a generated electric power can be delivered to the outside. The substrate is subjected to a reflection-preventing treatment, and one or both side thereof is transparent. Between the substrate and the cell may be disposed various kinds of plastic material such as ethylene vinyl acetate (EVA) to protect the cell or to improve a collector efficiency. Such a plastic material is may be used in a form of a film or a packing resin. In the case where the solar cell is used at a place where the surface of the cell is not necessarily covered with a hard material, such as a place without a shock from the outside, one of the substrate can be omitted by forming a surface protective layer of a transparent plastic film, or by hardening the above-described packing resin to give a protection function. The periphery of the substrates may be sandwiched and fixed by metallic flames, and the substrates and the flames may be sealed with a sealant in order to seal the interior of the cell and to secure rigidity of a module. Further, flexible materials may be used for the cell, the substrate, the packing agent and the sealant to constructing the solar cell on a curved surface.

The super straight type solar cell module may be manufactured by the following steps of: placing cells on a front substrate sent out from a substrate-supplying device together with lead lines for connecting a sealant to the cells and a sealant for back surface while carrying the front substrate by a belt conveyer, etc.; placing a back substrate or a back cover thereon; and setting flames at the outer edge portion.

The substrate type solar cell may be manufactured by the following steps of: placing cells on a substrate sent out from a substrate-supplying device together with lead lines for connecting the cells and a sealant, etc. while carrying the substrate by a belt conveyer, etc.; placing a front cover thereon; and setting flames at the outer edge portion.

Fig. 9 shows a structure of an embodiment of the substrate-integrated type solar cell produced by modularizing a photoelectric conversion device of the present invention. The solar cell shown in Fig. 9 has a structure where cells having a transparent electrically conductive layer 10a, a photosensitive layer 20 containing dye-adsorbed TiO₂, a charge transfer layer 30 and a metal counter electrically conductive layer 40 are modularized on one surface of a transparent substrate 50a, and a reflection-preventing layer 70 is applied on the other surface of the substrate. In such a structure, it is preferable to increase an area ratio of the photosensitive layer 20 observed from the substrate 50a side for enhancing an efficiency of utilizing incident light.

As for the solar cell shown in Fig. 9, a desired module structure can be obtained by patterning according to a semiconductor process technique such as selective metal plating, selective etching, CVD, PVD, etc., or a mechanical method such as laser scribing, plasma CVM, polishing, etc. so that the transparent electrically conductive layers, the photosensitive layers, the charge transfer layers and the counter electrode etc. are three-dimensionally arranged at a regular interval on the substrate. The plasma CVM is described in Solar Energy Materials and Solar Cells, 48, p 373 to 381, etc.

Other materials and processes used in the present invention will be described in detail below.

As a material for the sealant, various materials such as a liquid EVA (ethylene vinyl acetate), an EVA film, a mixture of fluorinated vinylidene copolymer and an acrylic resin, etc. may be used in accordance with objects such as application of weather-resistance or electric insulation, improvement in light-condensing efficiency, protection of a cell (improvement in impact resistance), etc. The outer edge of the module and the frame surrounding the fringe are preferably sealed with the sealant having high weather-resistance and moisture permeability. The strength and light transmittance of the sealed cell can be enhanced by adding a transparent filter into the sealant.

When the sealant is fixed on the cell, a method suited to a property of the sealant is preferably used. Various methods therefor may be used such as roll pressurization followed by thermal adherence, vacuum pressurization followed by thermal adherence, etc. for the film sealant, and roll coat, bar coat, spray coat, screen printing, etc. for the liquid or paste sealant.

It is preferable that a flexible material such as PET and PEN is used for a substrate, because after constructing the cells on a roll-like support, the sealing layer can be successively laminated according to the above-described methods to obtain a high productivity.

To increase a production efficiency of electric power, the light-taking surface of the substrate, generally a tempered glass substrate, of the module may be subjected to a reflection-preventing treatment. The reflection-preventing treatment may comprise laminating a reflection-preventing film, coating a reflection-preventing layer, etc.

The surface of the cell may be grooved or textured, thereby enhancing efficiency of utilizing incident light.

To increase a production efficiency of electric power, it is most important to taking light in the module without a loss, and it is also important to reflect light reached to the inside of the solar cell through a photoelectric conversion layer, and return effectively to the layer. The light reflectance may be increased by vapor-depositing or metal-plating the substrate with Ag, Al, etc. after a mirror plane-polishing, applying a layer comprising an Al-Mg alloy, an Al-Ti alloy, etc. as reflective layer at the lowest layer in the solar cell, making the lowest layer to a texture structure by annealing.

To increase the production efficiency of electric power, it is important to minimize a resistance of connection between cells, thereby preventing reduction in an inner voltage. The cells are generally connected each other by a wire bonding method or using an electrically conductive flexible sheet. In addition, the cells may be connected by methods such as electrically connecting while fixing the cells by an electrically conductive adhesives, adhesive tapes, etc., and pattern-coating an electrically conductive hot melt at an intended position.

A solar cell comprising a flexible support made of a polymer film, etc. may be manufactured by a method comprising the steps: forming cells in the same manner as described above while sending out a roll-like support; cutting it to an intended size; and sealing the marginal portion thereof with a flexible, moisture permeable material. The solar cell may have a module structure called "SCAF" described in Solar Energy Materials and Solar Cells, 48, p 383 to 391. Further, the solar cell comprising the flexible support may be used while adhered and fixed to a curved glass, etc.

As described above in detail, the solar cells comprising the photoelectric conversion device of the present invention may have various kinds of forms and functions in accordance with ends and environment of use.

### EXAMPLES

The present invention will be explained in more detail with reference to examples below. The present invention is not restricted by these examples.

### 1. Synthesis of Compound Represented by General Formula (1)

The compounds represented by the general formula (1) were synthesized, using the compounds **a** to **d** shown below. The structure of product was identified by ¹H-NMR. Water-content of the product was measured by Karl Fisher method, and the viscosity thereof was measured by the B-type viscometer manufactured by TOKIMEC INC.

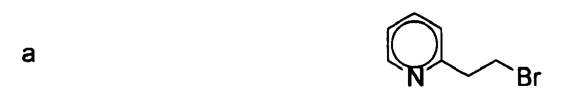

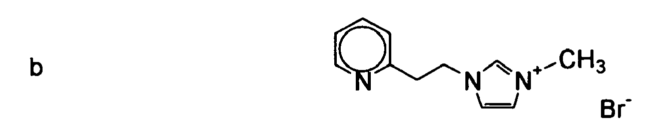

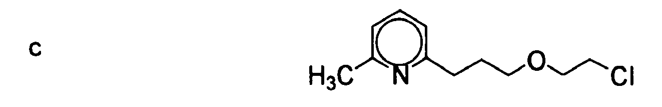

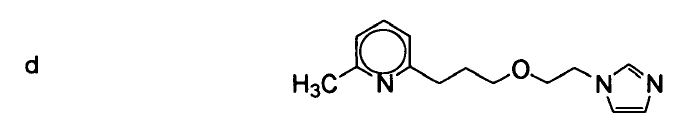

### (A) Synthesis of 1-a

5.58 g of the compound **a** and 3.7 g of *N*-methyl imidazole were dissolved in 15 ml of ethyl acetate, and reacted for 48 hours at room temperature. Then, from the reaction mixture was removed ethyl acetate phase by decantation, and the resultant was dried by heating under a reduced pressure to obtain 1.8 g of crude product containing the compound **b**.

1.8 g of the crude product and 3.0 g of sodium iodide were mixed in 20 ml of acetonitrile, and refluxed for 5 hours. Then, the reaction mixture was filtered to eliminate precipitates, and acetonitrile was distilled off under a reduced pressure therefrom. The residue was purified by silica gel column chromatography to obtain 1.0 g of 1-a. The water-content of the obtained 1-a was 0.3 %, and the viscosity (η) at 25 °C thereof was 832 cp or more.

### (B) Synthesis of 1-b

1.8 g of the above-mentioned crude product containing the compound **b** and 2.0 g of *N*-lithiotrifluoromethane sulfonimide were added to 20 ml of water, and stirred for 30 minutes at room temperature. Then, the reaction mixture was extracted with methylene chloride, and concentrated to obtain 1.7 g of oil. This was further dried for 5 hours under the condition of 50 °C and 5 mmHg to obtain 1-b. The water-content of the obtained 1-b was 0.15 %, and the viscosity (η) at 25 °C thereof was 355 cp or more.

### (C) Synthesis of 1-c

3.15 g of 1-a and 1.95 g of silver tetrafluoroborate were mixed in 25 ml of water. Then, the resultant solution was filtered through a celite to eliminate precipitates, and concentrated to remove water, followed by drying for 5 hours under the condition of 50 °C and 5 mmHg to obtain 1.8 g of 1-c. The water-content of the obtained 1-c was 0.2 %, and the viscosity (η) at 25 °C thereof was 1100 cp.

### (D) Synthesis of 4-b

1.8 g of 4-a and 1.33 g of *N-*lithiotrifluoromethane sulfonimide were added to 20 ml of water, and stirred for 1 hour at room temperature. Then, the reaction mixture was extracted with methylene chloride, and concentrated followed by drying for 5 hours under the condition of 50 °C and 5 mmHg to obtain 1.6 g of 4-b as oil. The water-content of the obtained 4-b was 0.2 %, and the viscosity (η) at 25 °C thereof was 333 cp or more.

### (E) Synthesis of 4-c

2.0 g of 4-a and 1.0 g of silver tetrafluoroborate were mixed in 20 ml of water. Then, the resultant solution was filtered through a celite to eliminate precipitates, and concentrated to remove water, followed by drying for 5 hours under the condition of 50 °C and 5 mmHg to obtain 1.3 g of 4-c as oil. The water-content of the obtained 4-c was 0.2 %, and the viscosity (η) at 25 °C thereof was 2000 cp.

### (F) Synthesis of 4-d

2.0 g of 4-a and 0.86 g of silver thiocyanate were mixed in 80 ml of water, and stirred for 48 hours. Then, the resultant solution was filtered through a celite to eliminate precipitates, and concentrated to remove water. The residue was purified by silica gel column chromatography, followed by drying for 5 hours under the condition of 50 °C and 5 mmHg to obtain 0.6 g of 4-d as oil. The water-content of the obtained 4-d was 0.3 %, and the viscosity (η) at 25 °C thereof was 2000 cp or more.

### (G) Synthesis of 4-e

3.87 g of 4-a and 2.3 g of silver trifluoro-acetate were mixed in 20 ml of water. Then, the resultant solution was filtered through a celite to eliminate precipitates, and concentrated to remove water. The residue was purified by silica gel column chromatography, followed by drying for 5 hours under the condition of 50 °C and 5 mmHg to obtain 1.4 g of 4-e as oil. The water-content of the obtained 4-e was 0.5 %, and the viscosity (η) at 25 °C thereof was 2000 cp or more.

### (H) Synthesis of 4-f

2.0 g of 4-a and 1.05 g of silver methanesulfonate were mixed in 20 ml of water. Then, the resultant solution was filtered through a celite to eliminate precipitates, and concentrated to remove water. The residue was purified by silica gel column chromatography, followed by drying for 5 hours under the condition of 50 °C and 5 mmHg to obtain 1.3 g of 4-f as oil. The water-content of the obtained 4-f was 0.5 %, and the viscosity (η) at 25 °C thereof was 2000 cp or more.

### (I) Syntheses of Other Compounds

The other compounds represented by the general formula (1) can be also easily synthesized in a similar method to above.

### 2. Production of Photo-Electrochemical Cell

### (A) Preparation of Titanium Dioxide Dispersion

A 200 ml inner volume of a stainless steel vessel coated with Teflon inside was charged with 15 g of titanium dioxide fine particles "Degussa P-25" manufactured by Nippon Aerosil K.K., 45 g of water, 1 g of dispersant "Triton X-100" manufactured by Aldrich, and 30 g of zirconia beads having a diameter of 0.5 mm manufactured by Nikkato K.K. These contents were subjected to a dispersion treatment for 2 hours at 1500 rpm by means of a sand-grinder mill manufactured by Imex K.K. The zirconia beads were removed by filtration to obtain the titanium dioxide dispersion. The average particle diameter of the titanium dioxide particles in the dispersion was 2.5 µm. Herein, the particle diameter was measured by Master Sizer manufactured by MALVERN.

### (B) Preparation of Dye-Adsorbed TiO₂ Electrode

The above dispersion was coated on an electrically conductive surface of a conductive glass having a fluorine-doped tin oxide layer by a glass bar. Used as the conductive glass was 20 mm × 20 mm of "TCO Glass-U" manufactured by Asahi Glass K.K. with a surface resistance of approximately 30 30Ω/square. A coating amount of the semiconductor fine particles was 20 g/m². Herein, on the eight glasses were coated the dispersion at once after adhesive tape was attached to a part of the conductive surface (3 mm from the edge) of each conductive glass as a spacer, and the glasses were arranged so that the adhesive tapes come to both edges thereof. The coated glasses were air-dried for a day at a room temperature after peeling the adhesive tapes. Then, the glasses were placed in an electric furnace "muffle furnace FP-32" manufactured by Yamato Science K.K., followed by calcinating at 450 °C for 30 minutes to obtain TiO₂ electrodes.

After the electrodes were taken out of the furnace and cooled, they were immersed in ethanol solution comprising the dye shown in Table 1 for 3 hours to adsorbing the dye, respectively. The concentration of the dye in the ethanol solution was 3 × 10⁻⁴ mol/l. The dye-adsorbed TiO₂ electrodes were further immersed in 4-*t*-butylpyridine for 15 minutes, then washed with ethanol and air-dried. The thickness of thus-obtained photosensitive layer was shown in Table 1, and an adsorbing amount of the dye was appropriately selected in a range of 0.1 to 10 mmol/m² according to the dye.

### (C) Production of Photo-Electrochemical Cell

The 20 mm × 20 mm in size of dye-sensitized TiO₂ electrode glass substrate prepared as described above was put on a platinum-vapor deposited glass having the same size. Next, an electrolyte composition was permeated into a crevice between the glasses through capillarity to be introduced into the TiO₂ electrode, thereby obtaining a photo-electrochemical cell. According to this example, the photo-electrochemical cell similar to that shown in Fig. 1 was prepared, where the conductive support of the electrically conductive glass comprising the transparent substrate 50a of glass and the electrically conductive layer 10a disposed thereon; the photosensitive layer 20 of the dye-sensitized TiO₂; the charge transfer layer 30; the counter electrically conductive layer 40 of platinum; and the transparent substrate 50a of glass were laminated in this order, and sealed with an epoxy-based sealant. Incidentally, in the case where the electrolyte composition has a high viscosity, whereby it is difficult to permeating it through capillarity, the photo-electrochemical cell was produced by the method comprising the steps of: warming the electrolyte composition to 50 °C; applying it on the TiO₂ electrode; sufficiently permeating the electrolyte composition into the electrode and removing air in the electrode under reduced pressure; and putting a platinum-deposited counter electrode glass thereon.

The above processes were repeatedly carried out while changing the electrolyte composition and the dye as shown in Table 1 to produce the photo-electrochemical cell of EXAMPLES 1 to 28 and COMPARATIVE EXAMPLES 1 to 15. The constitution of the electrolyte composition and the thickness of the photosensitive layer of each photo-electrochemical cell are shown in Table 1. The dye(s) used in each cell is also shown therein. In the Table 1, "BCE" represents bis(cyanoethyl) ether.

The compound represented by the general formula (1) used for the electrolyte composition has a substituent, a conjugate acid of a compound obtained by adding a hydrogen atom thereto exhibiting a pKa value of 3 to 15. Such a substituent is: a pyridyl group (the pKa value: 5) in the case of 1-a to 1-f and 15-c; an α-picolyl group (the pKa value: 6) in the case of 2-b, 2-c, 3-d, 3-e, 4-c to 4-f and 5-c; a 2-methylimidazolyl group (the pKa value: 8) in the case of 7-c. Further, the structure of compounds Y-1 and Y-3 to Y-8 used in the EXAMPLES and COMPARATIVE EXAMPLES will be illustrated below.

**Table 1.**

| Photo-Electrochemical Cell | Electrolyte Composition Comprising 2 weight % of Iodine | | Thickness of Photosensitive Layer µm | Dye (Mole Absorption µm Coefficient in DMF) |
|---|---|---|---|---|
| | Electrolyte Salt | Solvent | | |
| | (weight %) | (weight %) | | |
| Comp. Ex. 1 | Y-1(10) | BCE(88) | 6.5 | R-1(14000) |
| Ex. 1 | 1-a(10) | BCE(88) | 6.5 | R-1(14000) |
| Comp. Ex. 2 | Y-1(10) / Y-3(38) | BCE(50) | 6.5 | R-1(14000) |
| Comp. Ex. 3 | Y-1(10) / Y-3(58) | BCE(30) | 6.5 | R-1(14000) |
| Comp. Ex. 4 | Y-1(10) / Y-3(78) | BCE(10) | 6.5 | R-1(14000) |
| Ex. 2 | 1-a(10) / Y-3(58) | BCE(30) | 6.5 | R-1 (14000) |
| Ex. 3 | 1-a(10) / Y-3(78) | BCE(10) | 6.5 | R-1 (14000) |
| Ex. 4 | 1-a(10) / Y-3(88) | - | 6.5 | R-1(14000) |
| Comp. Ex. 5 | Y-1(70) / Y-3(28) | - | 6.5 | R-1(14000) |
| Comp. Ex. 6 | Y-1(70) / Y-4(28) | - | 6.5 | R-1(14000) |
| Comp. Ex. 7 | Y-1(70) / Y-6(28) | - | 6.5 | R-1(14000) |
| Comp. Ex. 8 | Y-1(70) / Y-7(28) | - | 6.5 | R-1(14000) |
| Comp. Ex. 9 | Y-1(70) / Y-8(28) | - | 6.5 | R-1(14000) |
| Ex. 5 | Y-1(70) / 1-b(28) | - | 6.5 | R-1(14000) |
| Ex. 6 | Y-1(70) / 1-c(28) | - | 6.5 | R-1(14000) |
| Ex. 7 | Y-1(70) / 1-d(28) | - | 6.5 | R-1(14000) |
| Ex. 8 | Y-1(70) / 1-e(28) | - | 6.5 | R-1(14000) |
| Ex. 9 | Y-1(70) / 1-f(28) | - | 6.5 | R-1(14000) |
| Ex. 10 | Y-1(70) / 2-b(28) | - | 6.5 | R-1(14000) |
| Ex. 11 | Y-1(70) / 2-c(28) | - | 6.5 | R-1(14000) |
| Ex. 12 | Y-1(70) / 4-c(28) | - | 6.5 | R-1(14000) |
| Ex. 13 | Y-1(70) / 4-d(28) | - | 6.5 | R-1(14000) |
| Ex. 14 | Y-1(70) / 4-e(28) | - | 6.5 | R-1(14000) |
| Ex. 15 | Y-1(70) / 4-f(28) | - | 6.5 | R-1(14000) |
| Ex. 16 | Y-5(70) / 4-d(28) | - | 6.5 | R-1(14000) |
| Ex. 17 | Y-5(70) / 4-e(28) | - | 6.5 | R-1(14000) |
| Ex. 18 | Y-5(70) / 3-d(28) | - | 6.5 | R-1(14000) |
| Ex. 19 | Y-5(70) / 3-e(28) | - | 6.5 | R-1(14000) |
| Ex. 20 | Y-1(70) / Y-4(20) / 4-c(8) | - | 6.5 | R-1(14000) |
| Ex. 21 | Y-1(70) / Y-4(23) / 5-c(5) | - | 6.5 | R-1(14000) |
| Ex. 22 | Y-1(70) / Y-4(20) / 7-c(8) | - | 6.5 | R-1(14000) |
| Ex. 23 | Y-5(70) / Y-6(18) / 4-d(10) | - | 6.5 | R-1(14000) |
| Ex. 24 | Y-5(70) / Y-7(18) / 4-e(10) | - | 6.5 | R-1(14000) |
| Ex. 25 | Y-1(70) / 1-b(28) | - | 4.8 | R-1(14000) |
| Ex. 26 | Y-1(70) / 1-b(28) | - | 3.3 | R-1(14000) |
| Ex. 27 | Y-1(70) / 2-c(28) | - | 3.3 | (5)(300000) and (26)(70000) |
| Ex. 28 | Y-1(70) / 4-c(28) | - | 3.3 | (9)(150000) and S-1(70000) |

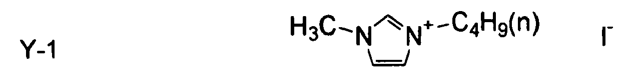

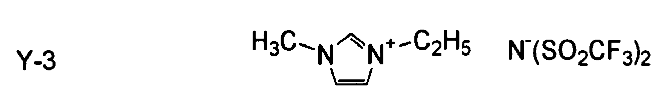

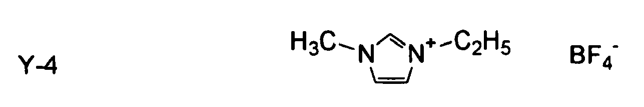

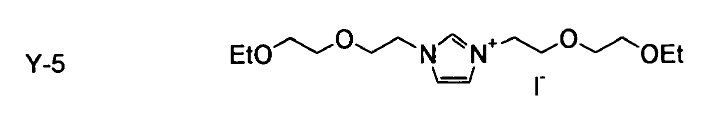

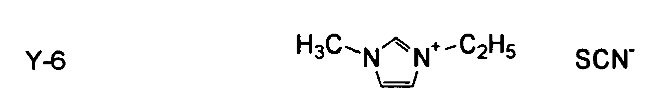

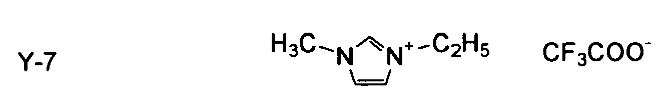

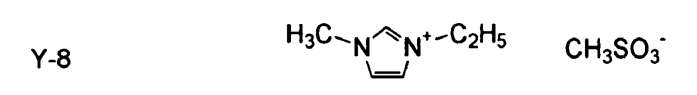

### 3. Measurement of Photoelectric Conversion Efficiency

A simulated sunlight was irradiated to the photo-electrochemical cells of EXAMPLES and COMPARATIVE EXAMPLES at 55 °C, and the generated electricity was measured by the current-voltage tester "Keithley SMU238", to obtain open circuit voltage (Voc), short-circuit current density (Jsc), fill factor (FF), photoelectric conversion efficiency (η), and decrease (%) of photoelectric conversion efficiency after storage in the dark for 80 hours with respect to each of the cells. The results are shown in Table 2. Incidentally, the simulated sunlight was obtained by passing the light of a 500 W xenone lamp manufactured by Ushio K.K. through an "AM 1.5 filter" manufactured by Oriel Co. and a sharp cut filter "Kenko L-42". The simulated sunlight was free of an ultraviolet radiation, and had intensity of 72 mW/cm².

**Table 2.**

| Photo-Electrochemical Cell | Open Circuit Voltage (Voc) V | Short-Circuit Current Density (Jsc) mA/cm² | Fill Factor (FF) | Photoelectric Conversion Efficiency (η) % | Decrease of η after Storage for 80 hours % |
|---|---|---|---|---|---|
| Comp. Ex. 1 | 0.60 | 9.7 | 0.66 | 5.3 | 91 |
| Ex. 1 | 0.65 | 9.3 | 0.67 | 5.6 | 66 |
| Comp. Ex. 2 | 0.52 | 6.6 | 0.65 | 3.1 | 43 |
| Comp. Ex. 3 | 0.47 | 6.1 | 0.65 | 2.6 | 35 |
| Comp. Ex. 4 | 0.43 | 6.0 | 0.66 | 2.4 | 26 |
| Ex. 2 | 0.63 | 6.8 | 0.64 | 3.8 | 18 |
| Ex. 3 | 0.60 | 6.5 | 0.65 | 3.5 | 10 |
| Ex. 4 | 0.58 | 6.3 | 0.64 | 3.2 | 5 |
| Comp. Ex. 5 | 0.41 | 6.0 | 0.65 | 2.2 | 4 |
| Comp. Ex. 6 | 0.55 | 6.7 | 0.66 | 3.4 | 6 |
| Comp. Ex. 7 | 0.51 | 7.5 | 0.64 | 3.4 | 6 |
| Comp. Ex. 8 | 0.56 | 6.9 | 0.62 | 3.3 | 7 |
| Comp. Ex. 9 | 0.54 | 6.8 | 0.63 | 3.2 | 7 |
| Ex. 5 | 0.60 | 7.2 | 0.63 | 3.8 | 5 |
| Ex. 6 | 0.64 | 7.3 | 0.64 | 4.2 | 6 |
| Ex. 7 | 0.62 | 7.5 | 0.63 | 4.1 | 6 |
| Ex. 8 | 0.66 | 7.0 | 0.63 | 4.0 | 5 |
| Ex. 9 | 0.65 | 7.1 | 0.61 | 3.9 | 7 |
| Ex. 10 | 0.59 | 7.1 | 0.65 | 3.8 | 6 |
| Ex. 11 | 0.63 | 7.1 | 0.66 | 4.1 | 4 |
| Ex. 12 | 0.64 | 7.2 | 0.64 | 4.1 | 5 |
| Ex. 13 | 0.63 | 7.6 | 0.63 | 4.2 | 5 |
| Ex. 14 | 0.67 | 7.1 | 0.63 | 4.2 | 6 |
| Ex. 15 | 0.66 | 7.2 | 0.61 | 4.0 | 5 |
| Ex. 16 | 0.65 | 7.8 | 0.63 | 4.4 | 5 |
| Ex. 17 | 0.68 | 7.3 | 0.63 | 4.3 | 5 |
| Ex. 18 | 0.66 | 7.9 | 0.63 | 4.6 | 6 |
| Ex. 19 | 0.68 | 7.4 | 0.63 | 4.4 | 5 |
| Ex. 20 | 0.65 | 7.4 | 0.65 | 4.3 | 5 |
| Ex. 21 | 0.64 | 7.4 | 0.65 | 4.3 | 6 |
| Ex. 22 | 0.64 | 7.6 | 0.65 | 4.4 | 5 |
| Ex. 23 | 0.64 | 7.8 | 0.63 | 4.4 | 6 |
| Ex. 24 | 0.67 | 7.3 | 0.63 | 4.3 | 6 |
| Ex. 25 | 0.60 | 6.7 | 0.64 | 3.6 | 5 |
| Ex. 26 | 0.60 | 6.5 | 0.64 | 3.5 | 4 |
| Ex. 27 | 0.62 | 7.2 | 0.66 | 4.1 | 5 |
| Ex. 28 | 0.63 | 7.5 | 0.65 | 4.3 | 6 |

As shown in Table 2, although the photoelectric conversion properties of the cells using the electrolyte composition with a large amount of solvent are remarkably worsened during the storage, the cells according to EXAMPLES 1 and 2 exhibit improved durability as compared with the cells of COMPARATIVE EXAMPLES 1, 2 and 3 using only prior art salts.

To suppress the decrease of the photoelectric conversion efficiency during the storage to 10 % or less, the electrolyte composition preferably comprises 10 weight % or less of solvent, more preferably comprises no solvent.

On the other hand, in the case of the cells comprising the electrolyte composition with no solvent, the cells of COMPARATIVE EXAMPLES 5 to 9 using only conventional imidazolium salts exhibit a low open circuit voltage and photoelectric conversion efficiency. As compared with this, the cells according to the present invention of EXAMPLES 4 to 28 exhibit a high open circuit voltage and improved conversion efficiency.

Further, it is clear from the results of EXAMPLES 16 and 19 that the cell comprising the electrolyte using a combination of salts having an ethyleneoxy group is excellent in the photoelectric conversion efficiency. As is clear from the results of EXAMPLES 5, 25 and 26, the thinner the photosensitive layer is, the more short-circuit current density is lowered. However, it is clear from the results of EXAMPLES 27 and 28 that the photoelectric conversion efficiency can be improved by using the dye having a high light-absorbability.

As explained above in detail, the electrolyte composition of the present invention is excellent in the durability and charge-transporting capability. The photoelectric conversion device comprising the electrolyte composition exhibits the excellent photoelectric conversion properties and less deterioration of the properties during the long-term use or storage. The photo-electrochemical cell composed of the device is remarkably useful as a solar cell.

## Claims

1. An electrolyte composition comprising a compound represented by the following general formula (1): 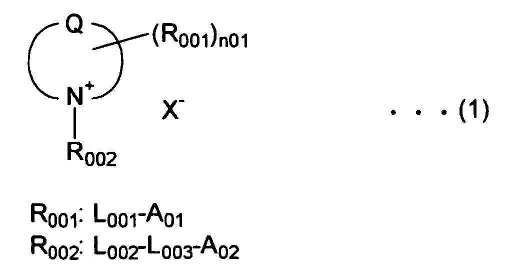 wherein Q represents an atomic group forming an aromatic cation having a 5-membered ring structure with a nitrogen atom;
R₀₀₁ represents L₀₀₁-A₀₁ (in which L₀₀₁ is a single bond or a divalent linking group, A₀₁ is a substituent when L₀₀₁ is a single bond, and A₀₁ is a hydrogen atom or a substituent when L₀₀₁ is a divalent linking group);
n01 represents 0 or an integer of 1 to the maximum number of R₀₀₁ attachable to Q, and F₀₀₁'s may be the same or different groups when n01 is 2;
R₀₀₂ represents L₀₀₂L₀₀₃-A₀₂ (in which L₀₀₂ is an unsubstituted alkylene group, L₀₀₃ is a single bond or a divalent linking group, and A₀₂ is a hydrogen atom or a substituent),
X⁻ represents an anion; and at least one of A₀₁ and A₀₂ is a substituent, a conjugate acid of a compound obtained by adding a hydrogen atom thereto exhibiting a pKa value of 3 to 15, wherein the aromatic cation formed by said Q is an imidazolium cation.

2. The electrolyte composition according to claim 1, wherein said Q is composed of atoms selected from the group consisting of carbon, hydrogen, nitrogen and oxygen atoms.

3. The electrolyte composition according to claim 1 or 2, wherein said compound represented by the general formula (1) is further represented by the following general formula (2): 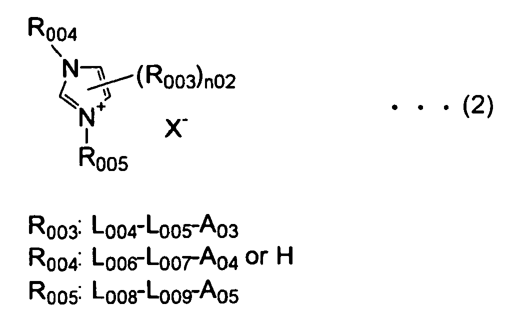 wherein R₀₀₃ represents L₀₀₄-L₀₀₅-A₀₃ (in which L₀₀₄ is an unsubstituted alkylene group, L₀₀₅ is a single bond or a divalent linking group, and A₀₃ is a hydrogen atom or a substituent);
n02 represents an integer of 0 to 1;
R₀₀₄ represents a hydrogen atom or L₀₀₆-L₀₀₇-A₀₄ (in which L₀₀₆ is an unsubstituted alkylene group, L₀₀₇ is a single bond or a divalent linking group, and A₀₄ is a hydrogen atom or a substituent);
R₀₀₅ represents L₀₀₈-L₀₀₉-A₀₅ (in which L₀₀₈ is an unsubstituted alkylene group, L₀₀₉ is a single bond or a divalent linking group, and A₀₅ is a hydrogen atom or a substituent);
X⁻ represents an anion; at least one of A₀₃ to A₀₅ is a substituent, a conjugate acid of a compound obtained by adding a hydrogen atom thereto exhibiting a pKa value of 3 to 8.

4. The electrolyte composition according to any one of claims 1 to 3, wherein said substituent, a conjugate acid of a compound obtained by adding a hydrogen atom thereto exhibiting a pKa value of 3 to 8, is an imidazolyl group.

5. The electrolyte composition according to any one of claims 1 to 4, wherein a solvent-content is 10 weight % or less based on the total thereof.

6. The electrolyte composition according to any one of claims 1 to 5, wherein said X⁻ is I⁻, NCS⁻, BF₄⁻, N⁻(CF₃SO₂)₂, or an anion represented by the following general formula (AN-1) or (AN-2):
R₀₁₃-COO⁻ (AN-1)
R₀₁₄₋SO₃⁻ (AN-2)
wherein R₀₁₃ is an unsubstituted alkyl group or a perfluoroalkyl group; and R₀₁₄ is an unsubstituted alkyl group or a perfluoroalkyl group.

7. The electrolyte composition according to any one of claims 1 to 6, comprising an iodine salt and/or iodine in addition to said compound represented by the general formula (1).

8. The electrolyte composition according to any one of claims 1 to 7, used for a photo-electrochemical cell.

9. A photoelectric conversion device having an electrically conductive layer, a photosensitive layer, a charge transfer layer and a counter electrode, wherein said charge transfer layer comprises said electrolyte composition according to any one of claims 1 to 8.

10. The photoelectric conversion device according to claim 9, wherein said photosensitive layer comprises semiconductor fine particles sensitized by a dye.

11. The photoelectric conversion device according to claim 10, wherein said semiconductor fine particles are metal chalcogenide fine particles.

12. The photoelectric conversion device according to claim 11, wherein said metal chalcogenide fine particles contain titanium oxide fine particles.

13. The photoelectric conversion device according to any one of claims 10 to 12, wherein said dye is a metal complex dye and/or a polymethine dye.

14. A photo-electrochemical cell composed of said photoelectric conversion device according to any one of claims 9 to 13.

15. An imidazolium compound represented by the following general formula (3): 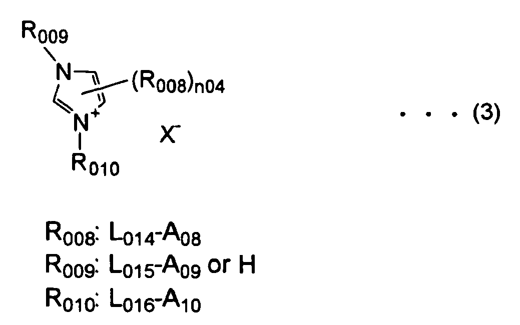 wherein R₀₀₈ represents L₀₁₄-A₀₈ (in which L₀₁₄ is a divalent linking group selected from the group consisting of an alkylene group, -O- and a combination thereof, and A₀₈ is a hydrogen atom or a substituent);
n04 represents an integer of 0 to 1;
R₀₀₉ represents a hydrogen atom or L₀₁₅-A₀₉ (in which L₀₁₅ is a divalent linking group selected from the group consisting of an alkylene group, -O- and a combination thereof, and A₀₉ is a hydrogen atom or a substituent);
R₀₁₀ represents L₀₁₆-A₁₀ (in which L₀₁₆ is a divalent linking group selected from the group consisting of an alkylene group, -O- and a combination thereof, and A₁₀ is a hydrogen atom or a substituent);
X⁻ represents an anion;
at least one of A₀₈ to A₁₀ is a substituent, a conjugate acid of a compound obtained by adding a hydrogen atom thereto exhibiting a pKa value of 3 to 8.

## Patentansprüche

1. Elektrolytzusammensetzung, umfassend eine Verbindung der nachstehenden allgemeinen Formel (1): 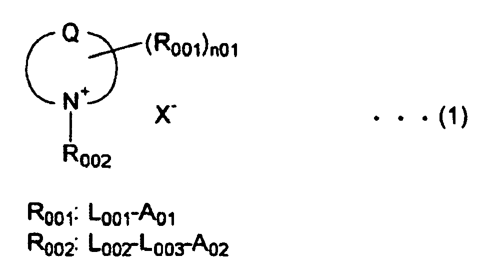 wobei Q eine Atomgruppe bedeutet, welche ein aromatisches Kation mit einer 5-gliedrigen Ringstruktur mit einem Stickstoffatom bildet;
R₀₀₁ für L₀₀₁-A₀₁ steht (wobei L₀₀₁ eine Einfachbindung oder eine 2-wertige Verknüpfungsgruppe ist, A₀₁ ein Substituent ist, wenn L₀₀₁ eine Einfachbindung ist und A₀₁ ein Wasserstoffatom oder ein Substituent ist, wenn L₀₀₁ eine 2-wertige Verbindungsgruppe ist);
n01 für 0 oder eine ganze Zahl von 1 bis zur Maximalzahl von mit Q verknüpfbaren R₀₀₁ steht und die R_{100's} die gleichen oder verschiedene Gruppen sein können, wenn n01 für 2 steht;
R₀₀₂ für L₀₀₂-L₀₀₃-A₀₂ steht (wobei L₀₀₂ eine unsubstituierte Alkylengruppe ist, L₀₀₃ eine Einfachbindung oder eine 2-wertige Verknüpfungsgruppe ist und A₀₂ ein Wasserstoffatom oder ein Substituent ist);
X- für ein Anion steht; und wenigstens eines von A₀₁ und A₀₂ ein Substituent, eine konjugierte Säure einer Verbindung ist, welche durch Hinzufügen eines Wasserstoffatoms erhalten wird und einen pKa-Wert von 3 bis 15 aufweist, wobei das durch Q gebildete aromatische Kation ein Imidazoliumkation ist.

2. Elektrolytzusammensetzung nach Anspruch 1, wobei Q aus Atomen zusammengesetzt ist, gewählt aus der Gruppe, bestehend aus Kohlenstoff-, Wasserstoff-, Stickstoff-, Sauerstoffatomen.

3. Elektrolytzusammensetzung nach Anspruch 1 oder 2, wobei die Verbindung mit der allgemeinen Formel (1) weiterhin durch die nachstehende allgemeine Formel (2) repräsentiert wird: 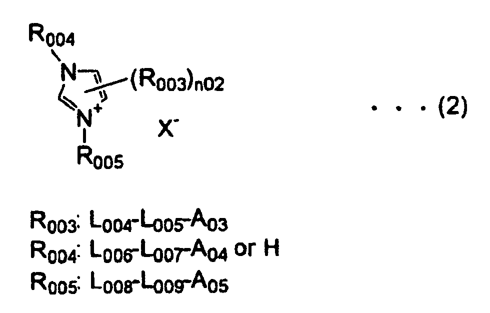 wobei R₀₀₃ für L₀₀₄-L₀₀₅-A₀₃ steht (worin L₀₀₄ eine unsubstituierte Alkylengruppe ist, L₀₀₅ eine Einfachbindung oder eine 2-wertige Verknüpfungsgruppe ist und A₀₃ ein Wasserstoffatom oder ein Substituent ist);
n02 eine ganze Zahl von 0 bis 1 bedeutet;
R₀₀₄ für ein Wasserstoffatom oder L₀₀₆-L₀₀₇-A₀₄ steht (wobei L₀₀₆ eine unsubstituierte Alkylengruppe ist, L₀₀₇ eine Einfachbindung oder eine 2-wertige Verknüpfungsgruppe ist und A₀₄ ein Wasserstoffatom oder ein Substituent ist);
R₀₀₅ für ein Wasserstoffatom oder L₀₀₈-L₀₀₉-A₀₅ steht (wobei L₀₀₈ eine unsubstituierte Alkylengruppe ist, L₀₀₉ eine Einfachbindung oder eine 2-wertige Verknüpfungsgruppe ist und A₀₅ ein Wasserstoffatom oder ein Substituent ist);
X- für ein Anion steht; und wenigstens eines von A₀₃ und A₀₅ ein Substituent, der eine konjugierte Säure einer Verbindung ist, welche durch Hinzufügen eines Wasserstoffatoms hierzu erhalten wird und einen pKa-Wert von 3 bis 8 aufweist

4. Elektrolytzusammensetzung nach einem der Ansprüche 1 bis 3, wobei der Substituent, der eine konjugierte Säure einer Verbindung ist, welche durch Hinzufügen eines Wasserstoffatoms hierzu erhalten wird und einen pKa-Wert von 3 bis 8 aufweist, eine Imidazolylgruppe ist.

5. Elektrolytzusammensetzung nach einem der Ansprüche 1 bis 4, wobei der Lösungsmittelgehalt 10 Gew.-% oder weniger, bezogen auf die Gesamtmenge, beträgt.

6. Elektrolytzusammensetzung nach einem der Ansprüche 1 bis 5, wobei X⁻ für I⁻, NCS⁻, BF₄⁻, N⁻(CF₃SO₂)₂ oder ein Anion der nachstehenden allgemeinen Formel (AN-1) oder (AN-2) steht:
R₀₁₃-COO⁻ (AN-1)
R₀₁₄-SO₃⁻ (AN-2)
wobei R₀₁₃ eine unsubstituierte Alkylgruppe oder eine Perfluoralkylgruppe ist, und R₀₁₄ eine unsubstituierte Alkylgruppe oder eine Perfluoralkylgruppe ist.

7. Elektrolytzusammensetzung nach einem der Ansprüche 1 bis 6, umfassend ein lodsalz und/oder Iod zusätzlich zu der durch die allgemeine Formel (1) repräsentierten Verbindung.

8. Elektrolytzusammensetzung nach einem der Ansprüche 1 bis 7 zur Verwendung als elektrochemische Photozelle.

9. Photoelektrische Umwandlungsvorrichtung mit einer elektrisch leitfähigen Schicht, einer lichtempfindlichen Schicht, einer Ladungsübertragungsschicht und einer Gegenelektrode, wobei die Ladungsübertragungsschicht die Elektrolytzusammensetzung nach einem der Ansprüche 1 bis 8 umfasst.

10. Photoelektrische Umwandlungsvorrichtung nach Anspruch 9, wobei die lichtempfindliche Schicht feine, mit Farbstoff sensibilisierte, Halbleiterteilchen umfasst.

11. Photoelektrische Umwandlungsvorrichtung nach Anspruch 10, wobei die feinen Halbleiterteilchen feine Metallchalkogenidteilchen sind.

12. Photoelektrische Umwandlungsvorrichtung nach Anspruch 11, wobei die feinen Metallchalkogenidteilchen feine Titandioxidteilchen sind.

13. Photoelektrische Umwandlungsvorrichtung nach einem der Ansprüche 10 bis 12, wobei der Farbstoff ein Metallkomplexfarbstoff und/oder ein Polymethinfarbstoff ist.

14. Elektrochemische Photozelle, umfassend die photoelektrische Umwandlungsvorrichtung nach einem der Ansprüche 9 bis 13,

15. lmidazoliumverbindung der nachstehenden allgemeinen Formel (3): 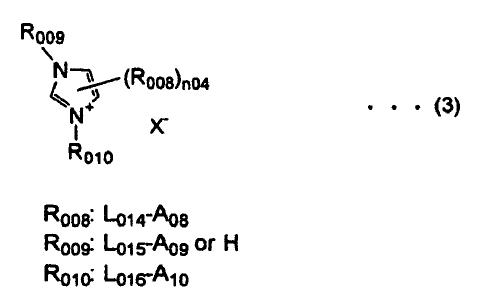 wobei R₀₀₈ für L₀₁₄-A₀₈ steht (wobei L₀₁₄ eine 2-wertige Verknüpfungsgruppe ist, gewählt aus der Gruppe, bestehend aus einer Alkylengruppe, -O- und einer Kombination davon, und A₀₈ ein Wasserstoffatom oder ein Substituent ist);
n04 eine ganze Zahl von 0 bis 1 bedeutet;
R₀₀₉ für L₀₁₅-A₀₉ steht (wobei L₀₁₅ eine 2-wertige Verknüpfungsgruppe ist, gewählt aus der Gruppe, bestehend aus einer Alkylengruppe, -O- und einer Kombination davon, und A₀₉ ein Wasserstoffatom oder ein Substituent ist);
R₀₁₀ für L₀₁₆-A₁₀ steht (wobei L₀₁₆ eine 2-wertige Verknüpfungsgruppe ist, gewählt aus der Gruppe, bestehend aus einer Alkylengruppe, -O- und einer Kombination davon, und A₁₀ ein Wasserstoffatom oder ein Substituent ist);
X⁻ für ein Anion steht;
wenigstens eines von A₀₈ bis A₁₀ ein Substituent, der eine konjugierte Säure einer Verbindung ist, die durch Hinzufügen eines Wasserstoffatoms hierzu erhalten wird und einen pKa-Wert von 3 bis 8 aufweist.

## Revendications

1. Composition d'électrolyte comprenant un composé représenté par la formule générale (1) suivants : 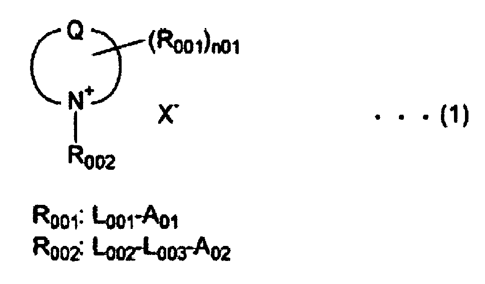 où Q représente un groupe atomique formant un cation aromatique ayant une structure d'anneau à 5 membres avec un atome d'azote ;
R₀₀₁ représente L₀₀₁-A₀₁ (où L₀₀₁ est une liaison simple ou un groupe de liaison divalent, A₀₁ est un substituant lorsque L₀₀₁ est une liaison simple, et A₀₁ est un atome d'hydrogène ou un substituant lorsque L₀₀₁ est un groupe de liaison divalent) ;
n01 représente 0 ou un entier de 1 au nombre maximum de R₀₀₁, attachable à Q, et les R₀₀₁ peuvent être des groupes identiques ou différents lorsque n01 est 2 ;
R₀₀₂ représente L₀₀₂-L₀₀₃-A₀₂ (où L₀₀₂ est un groupe alkylène non substitué, L₀₀₃ est une liaison simple ou un groupe de liaison divalent, et A₀₂ est un atome d'hydrogène ou un substituant),
X⁻ représente un anion ; et au moins un de A₀₁ et A₀₂ est un substituant, un acide conjugué d'un composé obtenu en ajoutant un atome d'hydrogène à celui-ci présentant une valeur pKa de 3 à 15, où le cation aromatique formé par ledit Q est un cation d'imidazolium.

2. Composition d'électrolyte selon la revendication 1, dans laquelle ledit Q est composé d'atomes choisis dans le groupe comprenant les atomes de carbone, d'hydrogène, d'azote et d'oxygène.

3. Composition d'électrolyte selon la revendication 1 ou 2, dans laquelle ledit composé représenté par la formule générale (1) est en outre représenté par la formule générale (2) suivants : 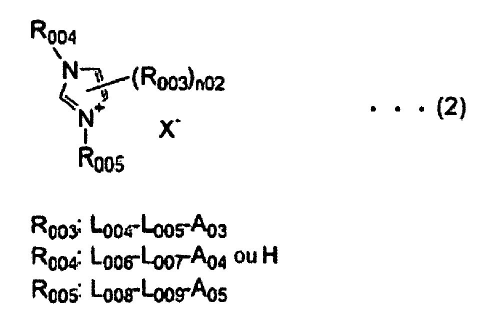 où R₀₀₃ représente L₀₀₄-L₀₀₅-A₀₃ (où L₀₀₄ est un groupe alkylène non substitué, L₀₀₅ est une liaison simple ou un groupe de liaison divalent, et A₀₃ est un atome d'hydrogène ou un substituant) ;
n02 représente un entier de 0 à 1 ;
R₀₀₄ représente un atome d'hydrogène ou L₀₀₆-L₀₀₇-A₀₄ (où L₀₀₆ est un groupe alkylène non substitué, L₀₀₇ est une liaison simple ou un groupe de liaison divalent, et A₀₄ est un atome d'hydrogène ou un substituant) ;
R₀₀₅ représente L₀₀₈-L₀₀₉-A₀₅ (où L₀₀₈ est un groupe alkylène non substitué, L₀₀₉ est une liaison simple ou un groupe de liaison divalent, et A₀₅ est un atome d'hydrogène ou un substituant) ;
X⁻ représente un anion ; au moins un de A₀₃ à A₀₅ est un substituant, un acide conjugué d'un composé obtenu en ajoutant un atome d'hydrogène à celui-ci présentant une valeur pKa de 3 à 8.

4. Composition d'électrolyte selon l'une quelconque des revendications 1 à 3, dans laquelle ledit substituant, un acide conjugué d'un composé obtenu en ajoutant un atome d'hydrogène à celui-ci présentant une valeur pKa de 3 à 8, est un groupe d'imidazolyle.

5. Composition d'électrolyte selon l'une quelconque des revendications 1 à 4, dans laquelle une teneur en solvant est de 10 % en poids ou moins, sur la base du total de celle-ci.

6. Composition d'électrolyte selon l'une quelconque des revendications 1 à 5, dans laquelle X⁻ est I⁻, NCS⁻, BF₄⁻, N⁻ (CF₃SO₂)₂, ou un anion représenté par la formule générale (AN-1) ou (AN-2) suivante :
**R₀₁₃-COO⁻** **(AN-1)**
**R₀₁₄-SO₃⁻** **(AN-2)**
où R₀₁₃ est un groupe alkyle non substitué ou un groupe perfluoroalkyle ; et R₀₁₄ est un groupe alkyle non substitué ou un groupe perfluoroalkyle.

7. Composition d'électrolyte selon l'une quelconque des revendications 1 à 6, comprenant un sel iodé et/ou de l'iode en plus dudit composé représenté par la formule générale (1).

8. Composition d'électrolyte selon l'une quelconque des revendications 1 à 7, utilisée pour une cellule photo-électrochimique.

9. Dispositif de conversion photoélectrique ayant une couche conductrice électriquement, une couche photosensible, une couche de transfert de charge et une contre-électrode, dans lequel ladite couche de transfert de charge comprend ladite composition d'électrolyte selon l'une quelconque des revendications 1 à 8.

10. Dispositif de conversion photoélectrique selon la revendication 9, dans lequel ladite couche photosensible comprend de fines particules semi-conductrices sensibilisées par un colorant.

11. Dispositif de conversion photoélectrique selon la revendication 10, dans lequel lesdites fines particules semi-conductrices sont de fines particules de chalcogénure métallique.

12. Dispositif de conversion photoélectrique selon la revendication 11, dans lequel lesdites fines particules de chalcogénure métallique contiennent de fines particules d'oxyde de titane.

13. Dispositif de conversion photoélectrique selon l'une quelconque des revendications 10 à 12, dans lequel ledit colorant est un colorant complexe métallique et/ou un colorant polyméthine.

14. Cellule photo-électrochimique composée dudit dispositif de conversion photoélectrique selon l'une quelconque des revendications 9 à 13.

15. Composé d'imidazolium représenté par la formule générale (3) suivante : 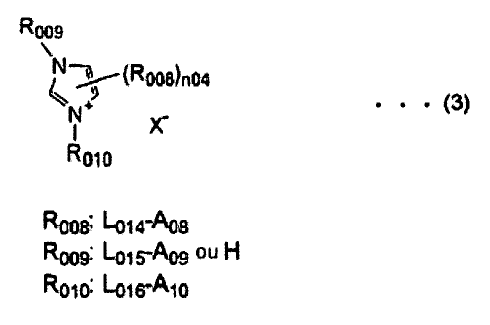 où R⁰⁰⁸ représente L₀₁₄-A₀₈ (où L₀₁₄ est un groupe de liaison divalent choisi dans le groupe comprenant un groupe alkylène, -O- et une combinaison de ceux-ci, et A₀₈ est un atome d'hydrogène ou un substituant)
n04 représente un entier de 0 à 1 ;
R₀₀₉ représente un atome d'hydrogène ou L₀₁₅-A₀₉ (où L₀₁₅ est un groupe de liaison divalent choisi dans le groupe comprenant un groupe alkylène, -O- et une combinaison de ceux-ci, et A₀₉ est un atome d'hydrogène ou un substituant) ;
R₀₁₀ représente L₀₁₆-A₁₀ (où L₀₁₆ est un groupe de liaison divalent choisi dans le groupe comprenant un groupe alkylène, -O- et une combinaison de ceux-ci, et A₁₀ est un atome d'hydrogène ou un substituant) ;
X⁻ représente un anion ;
au moins un de A₀₈ à A₁₀ est un substituant, un acide conjugué d'un composé obtenu en ajoutant un atome d'hydrogène à celui-ci présentant une valeur pKa de 3 à 8.
